# EUROPEAN PATENT APPLICATION

(11) **EP 3 438 150 A1**
(43) Date of publication of application: **06.02.2019**
(21) Application number: 17774782.1
(22) Date of filing: 24.03.2017
(51) Int. Cl.: C08G 61/12, H01L 29/786, H01L 51/05, H01L 51/30, H01L 51/46

(54) **NOVEL ORGANIC POLYMER AND METHOD FOR PRODUCING SAME**

(30) Priority: 29.03.2016 JP 2016066858
(71) Applicant: THE UNIVERSITY OF TOKYO, Tokyo 113-8654 (JP); Daicel Corporation, Osaka-shi, Osaka 530-0011 (JP)
(72) Inventor: OKAMOTO Toshihiro, Tokyo 113-8654 (JP); TAKEYA Junichi, Tokyo 113-8654 (JP); IKEDA Daiji, Tokyo 108-8230 (JP); IWAYA Masao, Tokyo 108-8230 (JP)
(74) Representative: Grünecker Patent- und Rechtsanwälte PartG mbB
(86) International application number: PCT/JP2017/012075
(87) International publication number: WO 2017/170245

(57) **Abstract**

Provided are a novel organic polymer useful for forming an organic semiconductor and a use of the novel organic polymer. A compound represented by the following formula (Ia) is subjected to a coupling reaction to give an organic polymer: 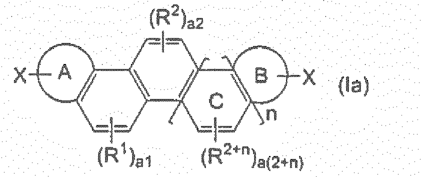 wherein a ring A and a ring B represent an aromatic hydrocarbon ring or an aromatic heterocyclic ring, n denotes an integer of 0 or 1 to 6, R¹ to R²⁺ⁿ represent a substituent (such as an alkyl group), a1 to a (2+n) denote an integer of 0 to 2, a ring C represents a benzene ring ortho-fused sequentially and nonlinearly to an adjacent benzene ring depending on the number of n, X represents a hydrogen atom, a halogen atom, a lithium atom, or -MgX¹ (wherein X¹ represents a halogen atom).

## Description

### TECHNICAL FIELD

The present invention relates to novel organic polymers (semiconductor polymers) and processes for producing the same useful for forming organic semiconductors used for semiconductor elements such as field-effect transistors and photoelectric conversion elements, as well as organic semiconductors and semiconductor devices (or electronic devices) containing the polymers.

### BACKGROUND ART

Polyacene compounds such as metal phthalocyanine, pentacene, and tetracene are known as organic compounds having semiconductor characteristics. However, these compounds have low solubility in organic solvents and are thus difficult to form films by coating, printing, or other means. A thin film of such a compound can only be formed by a vapor deposition process. Further, in a vapor deposition film of the compound, the phase of the HOMO orbital of the compound is periodically changed relative to the major axis direction of the molecule. Thus, in a case where the phase of the HOMO orbital shifts in the major axis direction of the molecule between molecules adjacent to each other in the thickness direction of the film, the electron conductivity between the molecules significantly decreases, and thus a high electrical conductivity cannot be achieved. Accordingly, in order to achieve a high carrier mobility, it is necessary to precisely control a state of producing an effective overlap of the HOMO orbitals.

Japanese Patent Application Laid-Open Publication No. 2013-197193 (JP 2013-197193 A, Patent Document 1) discloses an organic semiconductor thin film containing a compound (such as dinaphthothiophene) which has a W-shaped structure having a chalcogen-crosslinked moiety as a bending point and benzene rings connected as both flanks and which is represented by the following formula (A): 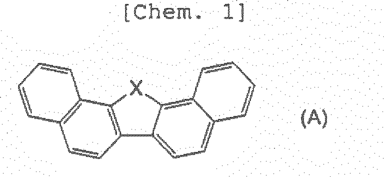 wherein X represents oxygen, sulfur, or selenium.

This compound has a fused (or condensed) ring structure in which the HOMO orbitals being in-phase continue in the major axis direction of the molecule, differently from a polyacene such as pentacene. Thus, even if the phase is a shifted in the major axis direction between molecules adjacent to each other in the thickness direction, the intermolecular electron mobility is hard to decrease. However, the above compound also has a low solubility in an organic solvent, and it is necessary to form a thin film by vapor deposition. Accordingly, semiconductor devices cannot be economically and advantageously manufactured.

WO 2013/125599 (Patent Document 2) discloses chalcogen compounds represented by the following formulas: 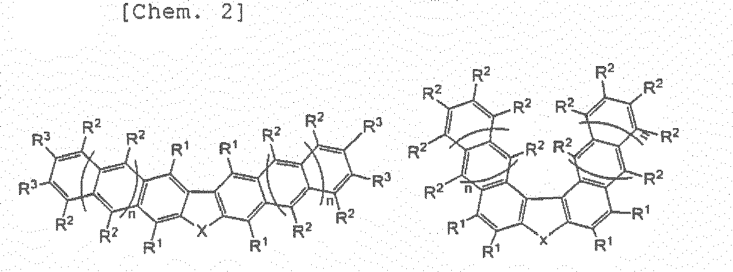 wherein X represents oxygen, sulfur, or selenium; n denotes 0 or 1, R¹ to R³ each independently represent hydrogen, fluorine, an alkyl having 1 to 20 carbon atoms, or others; provided that a case where all of R¹ to R³ are simultaneously hydrogen is excluded, and a case where X is sulfur and all of R¹ are simultaneously butyl is also excluded.

Japanese Patent Application Laid-Open Publication No. 2015-195361 (JP 2015-195361 A, Patent Document 3) discloses a coating solution for a nonluminous organic semiconductor device, comprising a compound having a thienobisbenzothiophene skeleton represented by the following formula and a solvent having a boiling point of 100°C or higher: 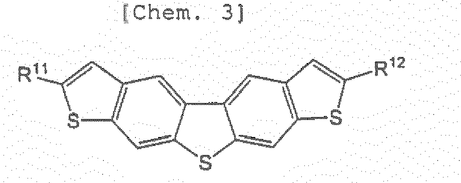 wherein R¹¹ and R¹² each independently represent a hydrogen atom, an alkyl group, an alkenyl group, an alkynyl group, or an alkoxy group and may have a substituent, and an aromatic moiety thereof may have a halogen atom as a substituent.

WO 2010/024388 (Patent Document 4) discloses an organic compound represented by the following formula (1), (5), or (6). 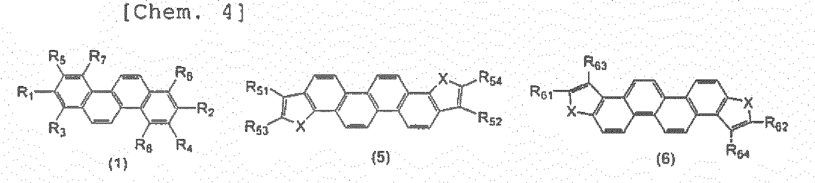 wherein at least one pair of adjacent two groups of R₁, R₃, R₅, and R₇ is bonded to each other to form an aromatic hydrocarbon ring or aromatic heterocyclic ring having 6 to 60 carbon atoms; at least one pair of adjacent two groups of R₂, R₄, R₆, and R₈ is bonded to each other to form an aromatic hydrocarbon ring or aromatic heterocyclic ring having 6 to 60 carbon atoms; each of the groups of R₁ to R₈ that do not form the aromatic hydrocarbon ring or aromatic heterocyclic ring independently represents a hydrogen atom, a halogen atom, an alkyl group having 1 to 30 carbon atoms, or others; X represents O, S, or N-Z; and R₅₁ to R₅₄, R₆₁ to R₆₄, and Z represent a hydrogen atom, a halogen atom, an alkyl group, a haloalkyl group, an alkoxyl group, or others.

This Document 4 describes, as a compound having a chrysene ring, chryseno[2,1-b:8,7-b']dithiophene, a chryseno[2,1-b:8,7-b']dithiophene having an alkyl group as a substituent at the 2-position of a thiophene ring thereof, or other compounds.

These compounds can provide some degree of carrier mobility in the major axis direction of the molecule. Unfortunately, these compounds, which are low molecular weight compounds, have a low thin-film strength and still insufficient carrier mobility.

### CITATION LIST

### PATENT LITERATURE

Patent Document 1: JP 2013-197193 A (Claims)
Patent Document 2: WO 2013/125599 (Claims)
Patent Document 3: JP 2015-195361 A (Claims)
Patent Document 4: WO 2010/024388 (Claims, [0119], and [0134])

### SUMMARY OF INVENTION

### TECHNICAL PROBLEM

It is therefore an object of the present invention to provide a novel organic polymer (a semiconductor polymer) useful for forming an organic semiconductor, a process for producing the organic polymer, as well as an organic semiconductor and a semiconductor device (or an electronic device) containing the organic polymer.

Another object of the present invention is to provide an organic polymer (a semiconductor polymer) having a high carrier mobility, a process for producing the organic polymer, and an organic semiconductor and a semiconductor device (or an electronic device) containing the organic polymer.

It is still another object of the present invention to provide an organic polymer (a semiconductor polymer) that has a high solubility in an organic solvent and can form a film by printing, coating, or other methods, a process for producing the organic polymer, as well as an organic semiconductor and a semiconductor device (or an electronic device) containing the organic polymer.

### SOLUTION TO PROBLEM

The inventors of the present invention made intensive studies to achieve the above objects and finally found the following matters: an aromatic compound having a plurality of adjacent benzene rings ortho-fused (or ortho-condensed) in a zigzag shape or configuration (or form) has a fused ring structure in which HOMO orbitals being in-phase continue in the major axis direction of a molecule thereof, and has a high intermolecular electron mobility; such an aromatic compound is subjected to a coupling reaction to produce a polymer having a π-conjugated aromatic fused ring and having a high thin-film strength and a significantly improved carrier mobility; and introduction of a specific group such as an alkyl chain into the polymer increases a solubility in an organic solvent without decrease in carrier mobility. The present invention was accomplished based on the above findings.

That is, an aspect of the present invention provides an organic polymer having a repeating unit represented by the following formula (I): 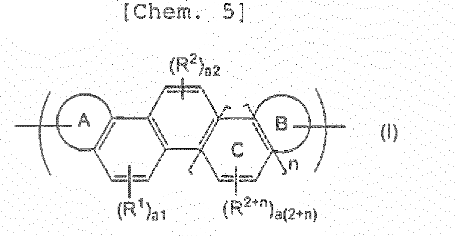 wherein a ring A and a ring B each independently represent an aromatic hydrocarbon ring or an aromatic heterocyclic ring; n denotes an integer of 0 or 1 to 6; R¹ to R²⁺ⁿ each independently represent a substituent; numbers a1 to a (2+n) each independently denote an integer of 0 to 2; and a ring C represents a benzene ring ortho-fused sequentially and nonlinearly to an adjacent benzene ring depending on the number of n.

The substituent may be a halogen atom, an alkyl group, a haloalkyl group, an alkenyl group, an alkynyl group, a cycloalkyl group, an aryl group, an aralkyl group, a heterocyclic ring group, a hydroxyl group, an alkoxy group, an alkylthio group, a haloalkoxy group, a haloalkylthio group, an aryloxy group, an arylthio group, a carboxyl group, an alkoxycarbonyl group, a cycloalkoxycarbonyl group, an aryloxycarbonyl group, a sulfonyl group, an alkylsulfonyl group, a haloalkylsulfonyl group, an amino group, an N-substituted amino group, an acyl group, an acyloxy group, an amide group, a nitro group, a cyano group, a silyl group, an alkylsilyl group, an alkylsilylethynyl group, or other groups.

The organic polymer represented by the above formula (I) may have a repeating unit represented by at least one formula of the following formulae (1-1) to (1-5) : 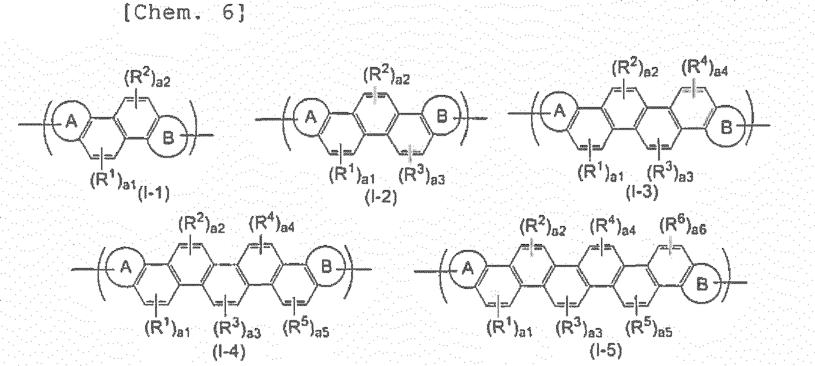 wherein R¹ to R⁶ each independently represent an alkyl group, an aryl group, an alkoxy group, or an alkylthio group; the numbers a1 to a6 each independently denote an integer of 0 to 2; and the ring A and the ring B have the same meanings as defined above.

At least one of R¹ to R⁶ may be a straight-chain or branched-chain C₄₋₂₈alkyl group or a straight-chain or branched-chain C₄₋₂₈alkoxy group, and the numbers a1 to a6 each may be independently an integer of 0 or 1. At least one of the numbers a1 to a6 may be 1.

The ring A and the ring B may represent an aromatic ring selected from the group consisting of a thiophene ring, a furan ring, a pyrrole ring, a selenophene ring, and a benzene ring.

The organic polymer may specifically have a repeating unit represented by the following formula (I-3a1) or (I-3b1): 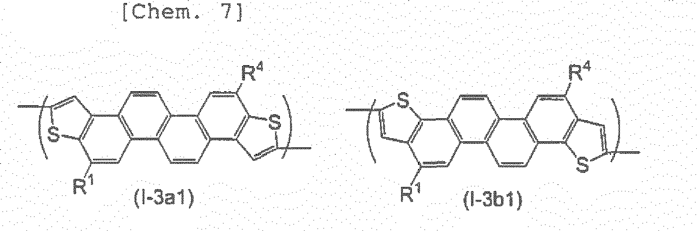 wherein R¹ and R⁴ represent a straight-chain or branched-chain C₆₋₂₆alkyl group or a straight-chain or branched-chain C₆₋₂₆alkoxy group.

The organic polymer may be produced by subjecting a compound represented by the following formula (Ia) to a coupling reaction: 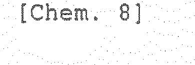 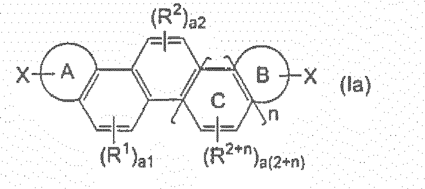 wherein X represents a hydrogen atom, a halogen atom, a lithium atom, or -MgX¹ (wherein X¹ represents a halogen atom), the ring A, the ring B, n, R¹ to R²⁺ⁿ, and the numbers a1 to a (2+n) have the same meanings as defined above.

Examples of X¹ may include a halogen atom such as a chlorine atom or a bromine atom.

The compound in which X is a halogen atom, a lithium atom, or -MgX¹ (a halomagnesio group) is a novel compound; and the compound in which at least one of benzene rings in a fused ring having a plurality of adjacent benzene rings ortho-fused each other nonlinearly has at least one of substituents R¹ to R²⁺ⁿ is also a novel compound.

The organic polymer has a high solubility in an organic solvent. Thus, another aspect of the present invention provides a composition for forming an organic semiconductor, the composition comprising the organic polymer and an organic solvent; and a process for producing an organic semiconductor, the process comprising coating at least one side of a base material with the composition and drying the coated layer to form an organic semiconductor.

A further aspect of the present invention provides an organic semiconductor containing the organic polymer, and an electronic device (for example, one device selected from a switching element, a rectifier element, and a photoelectric conversion element) containing the organic polymer.

Incidentally, when n is not less than 2 and the n number of rings C each are represented by C¹ to Cⁿ, the ring Cⁿ has a substituent (R²⁺ⁿ)ₐ₍₂₊ₙ₎. For example, when n is 2, there are four benzene rings ortho-fused each other between the ring A and the ring B, and two rings C (C¹ and C²) have substituents (R³)ₐ₃ and (R⁴)ₐ₄, respectively.

### ADVANTAGEOUS EFFECTS OF INVENTION

According to an aspect of the present invention, since the main chain of the π-conjugated polymer forms a fused ring in which benzene rings are fused in a zigzag shape or configuration in the major axis direction, the polymer has a significant HOMO orbital overlap, a high carrier mobility, and a high thin-film strength. Thus, the polymer is suitable for forming an organic semiconductor. Further, a long-chain alkyl chain or others is introduced to the polymer to increase a solubility of the polymer in an organic solvent and to enable the preparation of a coating composition and the formation of an organic semiconductor film by printing, coating, or other methods.

### BRIEF DESCRIPTION OF DRAWINGS

Fig. 1 is a schematic view of an organic semiconductor element in a field-effect transistor used in Examples.
Fig. 2 is an atomic force microscope (AFM) photograph of a surface of an organic semiconductor obtained in Examples.

### DESCRIPTION OF EMBODIMENTS

### [Organic polymer and composition containing the same]

In the above formula (I), the ring A and the ring B each independently represent an aromatic hydrocarbon ring or an aromatic heterocyclic ring. The aromatic hydrocarbon ring may include a benzene ring; a fused bi-to tetra-cyclic C₁₀₋₂₀ arene ring, for example, a bicyclic C₁₀₋₁₆arene ring such as a naphthalene ring; and a tricyclic arene ring (e.g., a fused tricyclic C₁₂₋₁₆arene ring such as anthracene or phenanthrene). A preferred aromatic hydrocarbon ring includes a benzene ring, a naphthalene ring, particularly a benzene ring.

The aromatic heterocyclic ring may include a single ring or fused ring having at least one heteroatom as a constituent atom of a ring thereof. Examples of the heteroatom may include an oxygen atom, a sulfur atom, a nitrogen atom, a selenium atom, a phosphorus atom, a silicon atom, a titanium atom, a zinc atom, and a germanium atom. The aromatic heterocyclic ring may have a plurality of heteroatoms, for example, the same or different heteroatoms. A preferred heteroatom includes a heteroatom selected from an oxygen atom, a sulfur atom, a nitrogen atom, and a selenium atom, particularly a sulfur atom. The heterocyclic ring having a heteroatom may be a three-membered to ten-membered ring and is usually five- or six-membered ring. Such a heterocyclic ring and an arene ring such as a benzene ring may be fused (or condensed).

A preferred aromatic heterocyclic ring may be a thiophene ring, a furan ring, a pyrrole ring, a selenophene ring, or other rings.

The ring A and the ring B are usually an aromatic heterocyclic ring in practical cases.

The number n denotes an integer of 0 or 1 to 6 and may usually be 0 or 1 to 5 (for example, 0 or 1 to 4) and preferably about 1 to 3 (for example, about 2 or 3). Moreover, the benzene ring represented by the ring C is ortho-fused sequentially and nonlinearly (preferably in a zigzag shape or configuration) to an adjacent benzene ring depending on the number of n. One or a plurality of rings C (benzene rings) is ortho-fused nonlinearly in the major axis direction to benzene rings adjacent to each other, differently from an anthracene ring, a naphthacene ring, a pentacene ring, or other linearly ortho-fused rings. Such ring(s) may be ortho-fused in a W-shaped or U-shaped form which may be gentle, like a dibenzo [a,j] anthracene ring or a pentaphene ring, or may be ortho-fused in a zigzag shape or configuration in which adjacent benzene rings share carbon atoms in 1,2-positions and carbon atoms in 3,4-positions, like a chrysene ring. A preferred ortho-fused shape is a zigzag shape or configuration. That is, for the compound in which n=1, a phenanthrene ring lies between the ring A and the ring B; for the compound in which n=2, a chrysene ring lies between the ring A and the ring B; and for the compound in which n=3, a picene ring lies between the ring A and the ring B.

The halogen atom represented by R¹ to R²⁺ⁿ may include fluorine, chlorine, bromine or iodine atom. The alkyl group may include, for example, a straight-chain or branched-chain C₁₋₃₀alkyl group such as methyl group, ethyl group, propyl group, isopropyl group, butyl group, i-butyl group, s-butyl group, t-butyl group, pentyl group, neopentyl group, hexyl group, heptyl group, n-octyl group, 2-ethylhexyl group, nonyl group, decanyl group, undecanyl group, dodecanyl group, tetradecyl group, hexadecyl group, 3-hexyltetradecyl group, or 3-octyltridecyl group. The alkyl group may usually be a straight-chain or branched-chain C₄₋₂₈alkyl group. In order to increase a solubility in an organic solvent, the alkyl group is advantageously a long-chain alkyl group, for example, a straight-chain or branched-chain C₆₋₂₆alkyl group, preferably a straight-chain or branched-chain C₆₋₂₄alkyl group (e.g., a straight-chain or branched-chain C₈₋₂₂alkyl group) . In order to impart a high solubility, the alkyl group is advantageously a branched-chain alkyl group.

The haloalkyl group may include, for example, a straight-chain or branched-chain C₁₋₃₀alkyl group having a halogen atom (such as fluorine, chlorine, or bromine atom), such as chloromethyl group, trichloromethyl group, trifluoromethyl group, pentafluoroethyl group, perchloroethyl group, perfluoroisopropyl group, or perfluorobutyl group (for example, a haloC₁₋₁₂alkyl group, preferably a haloC₁₋₆alkyl group).

The alkyl group and/or the haloalkyl group may have a substituent. Examples of such a substituent may include an alkoxy group (e.g., a C₁₋₁₀alkoxy group such as methoxy group or ethoxy group).

The alkenyl group may include, for example, a C₂₋₃₀alkenyl group such as vinyl group, allyl group, 2-butenyl group, or 4-pentenyl group, and may usually be a straight-chain or branched-chain C₃₋₁₈alkenyl group, e.g., a straight-chain or branched-chain C₄₋₁₆alkenyl group. Examples of the alkynyl group may include a C₂₋₃₀alkynyl group such as ethynyl group, 2-propynyl group, or 1-pentynyl group, and may usually be a straight-chain or branched-chain C₃₋₁₈alkynyl group, e.g., a straight-chain or branched-chain C₄₋₁₆alkynyl group.

As examples of the cycloalkyl group, there may be mentioned a C₃₋₁₀cycloalkyl group such as cyclohexyl group or cyclooctyl group. The aryl group may include, for example, a C₆₋₁₂aryl group such as phenyl group or naphthyl group, and a biC₆₋₁₂aryl group such as biphenyl group. Examples of the aralkyl group may include a C₆₋₁₂aryl-C₁₋₄alkyl group such as benzyl group or phenylethyl group.

The heterocyclic ring corresponding to the heterocyclic ring group may include an aromatic heterocyclic ring, for example, a nitrogen-containing heterocyclic ring such as pyridine, pyrazine, quinoline, naphthyridine, quinoxaline, phenazine, phenanthroline, or carbazole; a sulfur-containing heterocyclic ring such as thiophene, benzothiophene, dibenzothiophene, or thienothiophene; an oxygen-containing heterocyclic ring such as furan or benzofuran; a selenium-containing heterocyclic ring such as selenophene or benzoselenophene; and a heterocyclic ring having a plurality of heteroatoms, such as thiazole or benzothiazole.

Examples of the alkoxy group may include a straight-chain or branched-chain C₁₋₃₀alkoxy group corresponding to the alkyl group, e.g., hexyloxy group, octyloxy group, 2-ethylhexyloxy group, hexadecyloxy group, and 3-octyltridecyloxy group. The alkoxy group may usually be a straight-chain or branched-chain C₄₋₂₈alkoxy group or may be a long-chain alkoxy group, for example, a straight-chain or branched-chain C₆₋₂₆alkoxy group, preferably a straight-chain or branched-chain C₆₋₂₄alkoxy group (e.g., a straight-chain C₈₋₂₂alkoxy group). Examples of the alkylthio group may include a straight-chain or branched-chain C₄₋₂₈alkylthio group corresponding to the above alkoxy group. In order to increase the solubility in an organic solvent, the alkoxy group (for example, a long-chain alkoxy group) and the alkylthio group (for example, a long-chain alkylthio group) are also useful.

Examples of the haloalkoxy group may include a haloalkoxy group corresponding to the haloalkyl group, for example, a straight-chain or branched-chain C₁₋₃₀alkoxy group having a halogen atom (such as fluorine, chlorine, or bromine atom), such as chloromethoxy group, trichloromethoxy group, trifluoromethoxy group, trifluoroethoxy group, perfluoroisopropoxy group, or perfluorobutoxy group (for example, a haloC₁₋₁₂alkoxy group, preferably a haloC₁₋₆alkoxy group). As examples of the haloalkylthio group, there may be mentioned a haloalkylthio group corresponding to the haloalkoxy group.

The aryloxy group may include, for example, a C₆₋₁₂aryloxy group such as phenoxy group or naphthoxy group. Examples of the arylthio group may include a C₆₋₁₂arylthio group corresponding to the aryloxy group.

The alkoxycarbonyl group may include, for example, a straight-chain or branched-chain C₁₋₃₀alkoxy-carbonyl group such as methoxycarbonyl group, ethoxycarbonyl group, butoxycarbonyl group, t-butoxycarbonyl group, hexyloxycarbonyl group, octyloxycarbonyl group, 2-ethylhexyloxycarbonyl group, or 3-octyltridecyloxycarbonyl group.

Examples of the cycloalkoxycarbonyl group may include a C₃₋₁₀cycloalkyloxy-carbonyl group such as cyclohexyloxycarbonyl group. As the aryloxycarbonyl group, for example, there may be mentioned a C₆₋₁₂aryloxy-carbonyl group such as phenoxycarbonyl group. The alkylsulfonyl group may include, for example, a straight-chain or branched-chain C₁₋₄alkylsulfonyl group such as methylsulfonyl group. Examples of the haloalkylsulfonyl group may include a straight-chain or branched-chain haloC₁₋₄alkylsulfonyl group such as chloromethylsulfonyl group or trifluoromethylsulfonyl group.

The N-substituted amino group may include, for example, an N-monoC₁₋₆alkylamino group such as N-methylamino group or N-butylamino group; and an N,N-diC₁₋₆alkylamino group such as N,N-dimethylamino group, N,N-diethylamino group, or N,N-dibutylamino group.

Examples of the acyl group may include a C₁₋₃₀alkyl-carbonyl group such as acetyl group, propionyl group, and C₆₋₁₀aryl-carbonyl group such as benzoyl group. As the acyloxy group, for example, there may be mentioned a C₁₋₃₀alkyl-carbonyloxy group such as acetyloxy group or propionyloxy group, and a C₆₋₁₀aryl-carbonyloxy group such as benzoyloxy group.

The alkylsilyl group may include, for example, a C₁₋₄alkylsilyl group such as trimethylsilyl group. As the alkylsilylethynyl group, for example, there may be mentioned a C₁₋₄alkylsilylethynyl group such as trimethylsilylethynyl group.

Incidentally, a compound having an electron-withdrawing group (or an electron-accepting group) such as a halogen atom, a cyano group, a haloalkyl group, a haloalkoxyl group, or a haloalkylsulfonyl group can function as an n-type semiconductor; and a compound having an electron-donating group such as a hydrogen atom, an alkyl group, an alkoxyl group, or an N-substituted amino group can function as a p-type semiconductor.

The species of these substituents R¹ to R²⁺ⁿ may be the same or different. The species of these substituents may be different or the same according to the positions of the benzene rings between the ring A and the ring B. Among these substituents, in order to increase the solubility in an organic solvent, the alkyl group (a straight-chain or branched-chain long-chain alkyl group) and the alkoxy group (a straight-chain or branched-chain long-chain alkoxy group) are preferred. Moreover, the aryl group may contribute to a carrier mobility.

The numbers a1 to a(2+n) each independently represent an integer of 0 to 2 and is usually 0 or 1 in practical cases. Moreover, at least one of a1 to a (2+n) is "1", that is, there is no case where all of a1 to a (2+n) are "0" simultaneously, and in many cases, there is at least one of the substituents R¹ to R²⁺ⁿ. According to the values of the numbers a1 to a (2+n), the species of the substituents R¹ to R²⁺ⁿ may be the same or different. For example, substituents of the same benzene ring may be the same or different, or substituents of different benzene rings may be the same or different.

Any benzene ring (s) between the ring A and the ring B may be substituted by the substituent. The position (s) of any of the substituents R¹ to R²⁺ⁿ with respect to the corresponding benzene ring(s) between the ring A and the ring B is not particularly limited. In many cases, the benzene ring adjacent to the ring A and the benzene adjacent to the ring B (the benzene rings positioned at both ends of fused benzene rings other than (or excluding) the ring A and the ring B in the formula (1)) have the substituent.

Concrete examples of the repeating unit represented by the above-mentioned formula (I) may include a repeating unit represented by at least one formula of the following formulae (I-1) to (1-5): 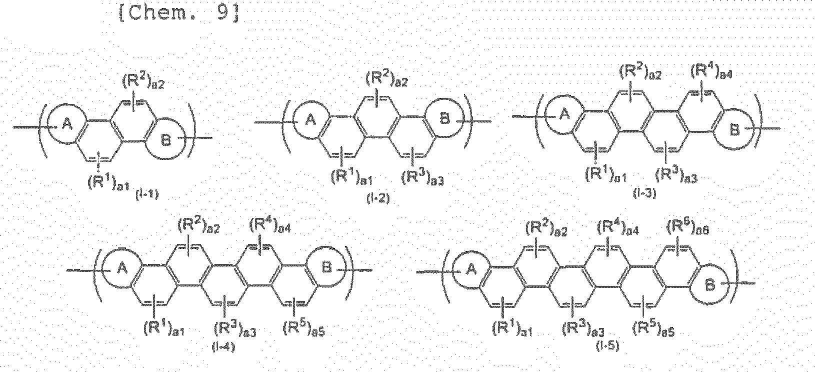 wherein the ring A, the ring B, R¹ to R⁶, and a1 to a6 have the same meanings as defined above.

It is often the case that R¹ to R⁶ each are independently an alkyl group, an aryl group, an alkoxy group (particularly, an alkyl group, an alkoxy group); and it is often the case that a1 to a6 each are independently 0 or 1.

The polymer having such a repeating unit has a high carrier mobility and is useful as an organic semiconductor. Concrete examples of these repeating units may include a unit represented by the formula (1-2) having a phenanthrene ring, a unit represented by the formula (I-3) having a chrysene ring, and a unit represented by the formula (1-4) having a picene ring. For the preparation of the polymer, the unit represented by the formula (1-2) or the formula (1-3) is useful. For example, a representative repeating unit can be represented by the following formula (I-3): 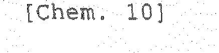 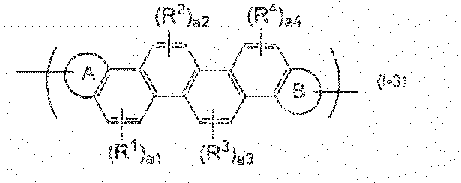 wherein the ring A, the ring B, R¹ to R⁴, and a1 to a4 have the same meanings as defined above.

Further, concrete examples of the unit represented by the formula (1-3) having a chrysene ring may include units represented by the following formulae (I-3a) to (I-3i): 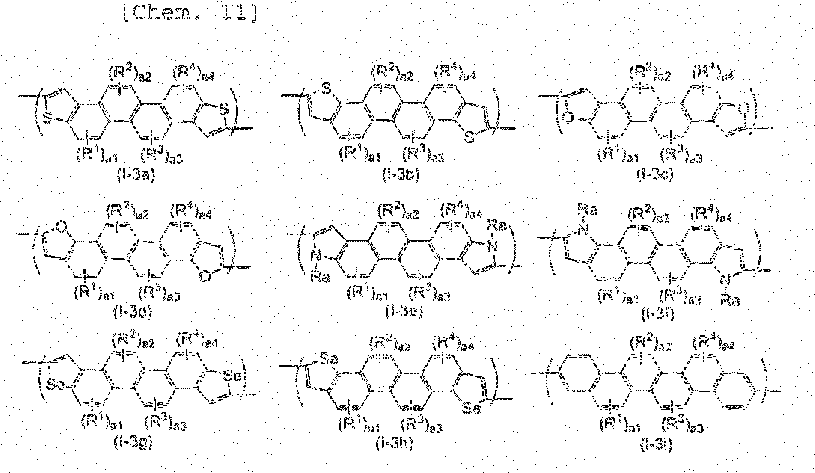 wherein Ra represents a hydrogen atom, an alkyl group, or an acyl group, R¹ to R⁴ and a1 to a4 have the same meanings as defined above.

The alkyl group represented by Ra may include a straight-chain or branched-chain C₁₋₆alkyl group such as methyl group, ethyl group, propyl group, isopropyl group, butyl group, or isobutyl group. As examples of the acyl group, there may be mentioned a straight-chain or branched-chain C₁₋₄alkyl-carbonyl group such as acetyl group or propionyl group.

Incidentally, in the formula (1-3) and the formulae (I-3a) to (I-3i), it is often the case that at least one of R¹ to R⁴ is a long-chain alkyl group (for example, a straight-chain or branched-chain C₄₋₂₈alkyl group) and/or a long-chain alkoxy group (for example, a straight-chain or branched-chain C₄₋₂₈alkoxy group), and it is often the case that a1 to a4 each independently denote 0 or 1 and at least one of a1 to a4 is 1 (that is, a1 to a4 each are not 0 simultaneously) . It is often the case that the benzene ring adjacent to the ring A and the benzene ring adjacent to the ring B have such an alkyl group and/or alkoxy group. That is, a1 and a4 among a1 to a4 are 1 in many cases.

A representative unit represented by the formula (I-3) can be, for example, represented by the following formula (I-3a1) or (I-3b1): 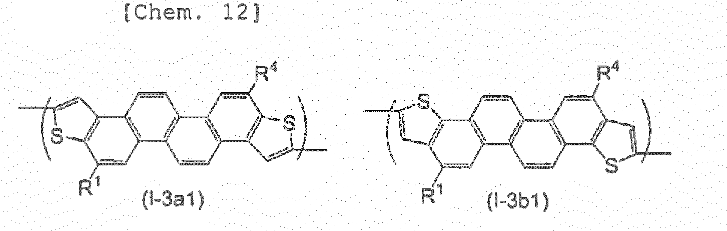 wherein R¹ and R⁴ represent a straight-chain or branched-chain C₆₋₂₆alkyl group or a straight-chain or branched-chain C₆₋₂₆alkoxy group.

In an embodiment of the present invention, the organic polymer (semiconductor polymer or π-conjugated polymer) may be a homopolymer or copolymer containing the repeating unit represented by the formula (I). The proportion of the repeating unit (I) in all repeating units of the organic polymer may be 10 to 100% by mol. In order to increase the carrier mobility, the proportion may be, for example, about 50 to 100% by mol, preferably about 60 to 100% by mol (e.g., about 70 to 99% by mol), and more preferably about 80 to 100% by mol (particularly about 80 to 95% by mol). Incidentally, the copolymer may be a polymer belonging to the category represented by the formula (I) and containing a plurality of different repeating units, for example, a copolymer containing a plurality of repeating units selected from units with different number n (the number of benzene rings) (e.g., the unit represented by the formula (I-2), the unit represented by the formula (I-3), and the unit represented by the formula (I-5)) and a copolymer containing units in which configurations are different from each other (e.g., a copolymer containing the unit represented by the formula (I-3a1) and the unit represented by the formula (I-3b1)); or may be a copolymer containing the repeating unit represented by the formula (I) and a structural unit other than the repeating unit (for example, a unit such as a polythiophene or a dibenzothiophene).

The molecular weight of the organic polymer is not particularly limited to a specific one. For example, when measured in terms of polystyrene by gel permeation chromatography (GPC), the number-average molecular weight Mn may be about 0.5 × 10³ to 5 × 10⁶ (e.g., about 1 × 10³ to 1 × 10⁶), preferably about 3 × 10³ to 7 × 10⁵ (e.g., about 5 × 10³ to 5 × 10⁵), and more preferably about 1 × 10⁴ to 1 × 10⁵, and the weight-average molecular weight Mw may be about 1 × 10³ to 5 × 10⁷ (e.g., about 3 × 10³ to 1 × 10⁷), preferably about 5 × 10³ to 7 × 10⁶ (e.g., about 1 × 10⁴ to 5 × 10⁶), and more preferably about 5 × 10⁴ to 1 × 10⁶. The molecular weight distribution (Mw/Mn) is, for example, about 1 to 20, preferably about 1.5 to 15, and more preferably about 2 to 10. Incidentally, in an embodiment of the present invention, the molecular weight distribution (Mw/Mn) can also be adjusted to about 1 to 3 (e.g., about 1.1 to 2.5) and preferably about 1 to 2 (e.g., about 1.1 to 1.7).

In an embodiment of the present invention, the glass transition temperature (Tg) of the organic polymer may not be observed at 0 to 500°C when measured by a differential scanning calorimeter. Accordingly, there is a possibility that the Tg is even higher than 500°C.

The organic polymer may be crystalline or amorphous. When measured by a differential scanning calorimeter, the melting point Tm may not be observed. It is often the case that the organic polymer is an amorphous organic polymer.

In an embodiment of the present invention, the organic polymer (semiconductor polymer or π-conjugated polymer) forms a π-conjugated system (π-conjugated polymer) having an aromatic fused ring in which a plurality of adjacent benzene rings is ortho-fused in a zigzag shape or configuration, and the organic polymer has a significant overlap of electron cloud (HOMO orbital), a high carrier mobility, and excellent semiconductor characteristics. Further, the organic polymer, which is a polymerized product, has a high mechanical strength even when formed into a thin film. The organic polymer, which has ortho-fused benzene rings, the ring A, and the ring B, has not only a high heat resistance but also a high stability including a chemical stability such as hydrolysis resistance. Further, an alkyl group or other groups can be introduced as a side chain of the aromatic ring to increase the solubility in an organic solvent and to improve the film formability of the polymer. An aspect of the present invention also includes a composition containing the organic polymer and an organic solvent. Such a composition is useful for forming an organic semiconductor thin film by printing, coating (application), or other means. Thus, a thin film (a semiconductor thin film) is easily formed by printing or application (coating).

The organic solvent may include, for example, an alicyclic hydrocarbon compound (such as cyclohexane), an aromatic hydrocarbon compound (such as benzene, toluene, or xylene), a halogenated hydrocarbon compound (such as dichloromethane, chloroform, chlorobenzene, or dichlorobenzene), an ether compound (a cyclic ether such as dioxane or tetrahydrofuran, and a chain ether such as diethyl ether or diisopropyl ether), a ketone compound (such as acetone or methyl ethyl ketone), an ester compound (such as ethyl acetate), a nitrile compound (such as acetonitrile), an amide compound (such as dimethylformamide or dimethylacetamide), and a sulfoxide compound (such as dimethyl sulfoxide). These solvents may be used as a mixed solvent. Among these solvents, it is often the case that the hydrocarbon compound (an alicyclic and/or aromatic hydrocarbon compound), the halogenated hydrocarbon compound, and the ether compound are used.

In the composition, the concentration of the organic polymer is not particularly limited to a specific one and may be, for example, about 0.01 to 20% by weight (e.g., about 0.05 to 10% by weight) and preferably about 0.1 to 5% by weight (e.g., about 0.2 to 2.5% by weight).

If necessary, in the range that the carrier transporting properties are not damaged, the composition may contain various additives, a levelling agent, an adhesion improver (such as a silane coupling agent), a dopant, or other agents.

In an embodiment of the present invention, the composition can form a uniform coated layer (or thin film) on a base material or substrate by printing or coating. In particular, the composition can form a thin film having a high surface smoothness (a thin film being homogeneous and having a high surface accuracy). Thus, the composition is useful for forming a semiconductor thin film.

In an embodiment of the present invention, the composition may be prepared by a conventional method, for example, mixing the organic polymer and the organic solvent to dissolve the organic polymer and optionally filtering the resulting mixture.

### [Compound represented by formula (Ia), and process for producing organic polymer including the compound]

In an embodiment of the present invention, the organic polymer can be prepared by subjecting a compound represented by the following formula (Ia) to a coupling reaction: 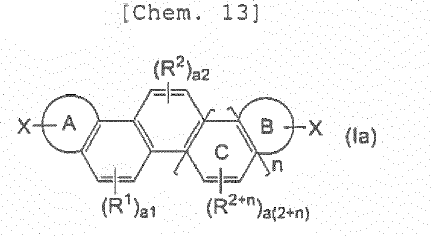 wherein X represents a hydrogen atom, a halogen atom, a lithium atom, or -MgX¹, the ring A, the ring B, n, R¹ to R²⁺ⁿ, a1 to a (2+n), and X¹ have the same meanings as defined above.

The halogen atom represented by X and X¹ may include a chlorine atom, a bromine atom, an iodine atom, or other atoms. In the formula (Ia), the species of X bonded to the ring A and the species of X bonded to the ring B may be the same or different.

The compound represented by the above formula (Ia) in which X is a halogen atom, a lithium atom, or -MgX¹ is a novel compound; and the compound represented by the above formula (Ia) which has at least one substituent of R¹ to R²⁺ⁿ (the compound in which at least one of the numbers a1 to a(2+n) is an integer of not less than 1) is also a novel compound. Concrete examples of the compound represented by the formula (Ia) may include compounds represented by the following formulae (Ia-1) to (Ia-5) (the compounds corresponding to the repeating units represented by the above formulae (I-1) to (I-5)): 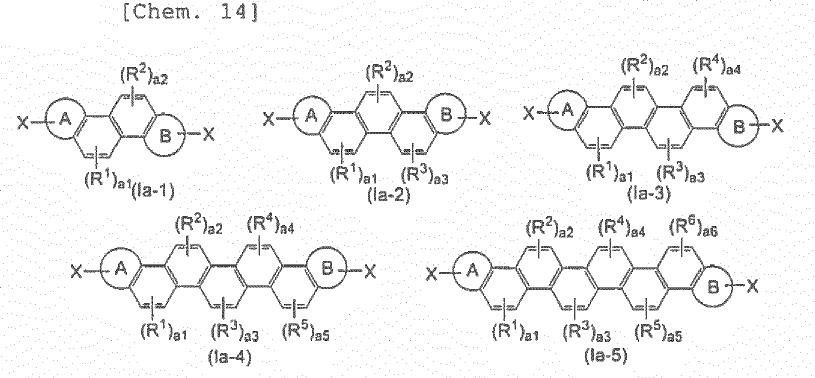 wherein X represents a halogen atom or a lithium atom, a1 to a6 each independently denote an integer of 0 to 2, at least one of a1 to a6 is 1, and the ring A, the ring B, and R¹ to R⁶ have the same meanings as defined above.

In the compounds represented by the formulae (Ia-1) to (Ia-5), it is often the case that at least one of R¹ to R⁶ (for example, substituents of benzene rings positioned at both ends of the ortho-fused ring (the benzene ring adjacent to the ring A and the benzene ring adjacent to the ring B) is an alkyl group (for example, a long-chain alkyl group) and/or an alkoxy group (e.g., a long-chain alkoxy group).

For the coupling reaction (homocoupling reaction), a reaction to be used may include, according to the species of X, an organic metal polycondensation reaction using various coupling catalysts, for example, a Grignard reagent and a transition metal complex such as a palladium catalyst (a palladium complex such as a palladium(0) catalyst), a nickel catalyst (a nickel complex such as a nickel (0) catalyst), or an iron catalyst (an iron complex such as an iron (III) catalyst), a reaction by an oxidation polymerization (including an electrolytic polymerization), or other reactions. In the organic metal polycondensation reaction, a single catalyst or a plurality of catalysts may be used.

These catalysts may be used alone or in combination. A preferred coupling catalyst includes, for example, a palladium(0) complex, a nickel catalyst (a nickel(0) complex such as bis(1,5-cyclooctadiene)nickel (Ni(cod)₂)), and an iron catalyst [an iron(III) catalyst (a Kochi-Furstner coupling catalyst) such as an acetylacetonato complex, a triphenylphosphine complex, or an alkoxy complex). Incidentally, use of the nickel catalyst enables the production of a polymer having a narrow molecular weight distribution.

The amount to be used of the catalyst may be about 0.001 to 10 mol, preferably about 0.01 to 5 mol, and more preferably about 0.1 to 2.5 mol relative to 1 mol of the compound represented by the formula (Ia).

The reaction may be carried out in the presence of a base, for example, triethylamine, pyridine, bipyridyl, and a lithium compound (such as lithium tetramethylpiperidide or n-butyllithium).

Incidentally, the reaction may be carried out under an inert atmosphere (for example, nitrogen, helium, and argon) in the absence or presence of a solvent inert (or inactive) to the reaction. The solvent includes a solvent in which the compound represented by the above formula (Ia) is soluble. Examples of the solvent may include an aromatic hydrocarbon compound (such as benzene, toluene, or xylene), a halogenated hydrocarbon compound (such as dichloromethane, chloroform, chlorobenzene, or dichlorobenzene), an ether compound (a cyclic ether such as dioxane or tetrahydrofuran, and a chain ether such as diethyl ether or diisopropyl ether), a ketone compound (such as acetone or methyl ethyl ketone), an ester compound (such as ethyl acetate), a nitrile compound (such as acetonitrile), an amide compound (such as dimethylformamide, dimethylacetamide, or N-methylpyrrolidone), and a sulfoxide compound (such as dimethyl sulfoxide). These solvents may be used as a mixed solvent.

The reaction temperature may be, for example, selected from a wide range of about -100°C to 120°C depending on the species of the catalyst. When the nickel complex is used, the reaction temperature may usually be about 50 to 120°C and preferably about 80 to 110°C; when the iron complex is used, the reaction temperature may usually be about -100°C to 50°C and preferably -80°C to 30°C.

After completion of the reaction, if necessary, the reaction mixture may be purified by a conventional separation and purification method, for example, concentration, decantation, reprecipitation, and chromatography, to give the organic polymer.

If necessary, the organic polymer may be fractionated into one or a plurality of fractions with specific molecular weights by an operation such as chromatography or extraction.

### [process for producing compound represented by formula (Ia)]

The compound represented by the formula (Ia) can be prepared by a conventional method. For example, the compound represented by the formula (Ia-3) can be prepared according to the following reaction scheme. Incidentally, a compound (10) is a known compound and can be prepared in accordance with Example 10 of the above-mentioned Patent Document 4. Thus, in the following reaction scheme, another process for preparing the compound (10) is shown.

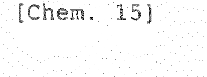

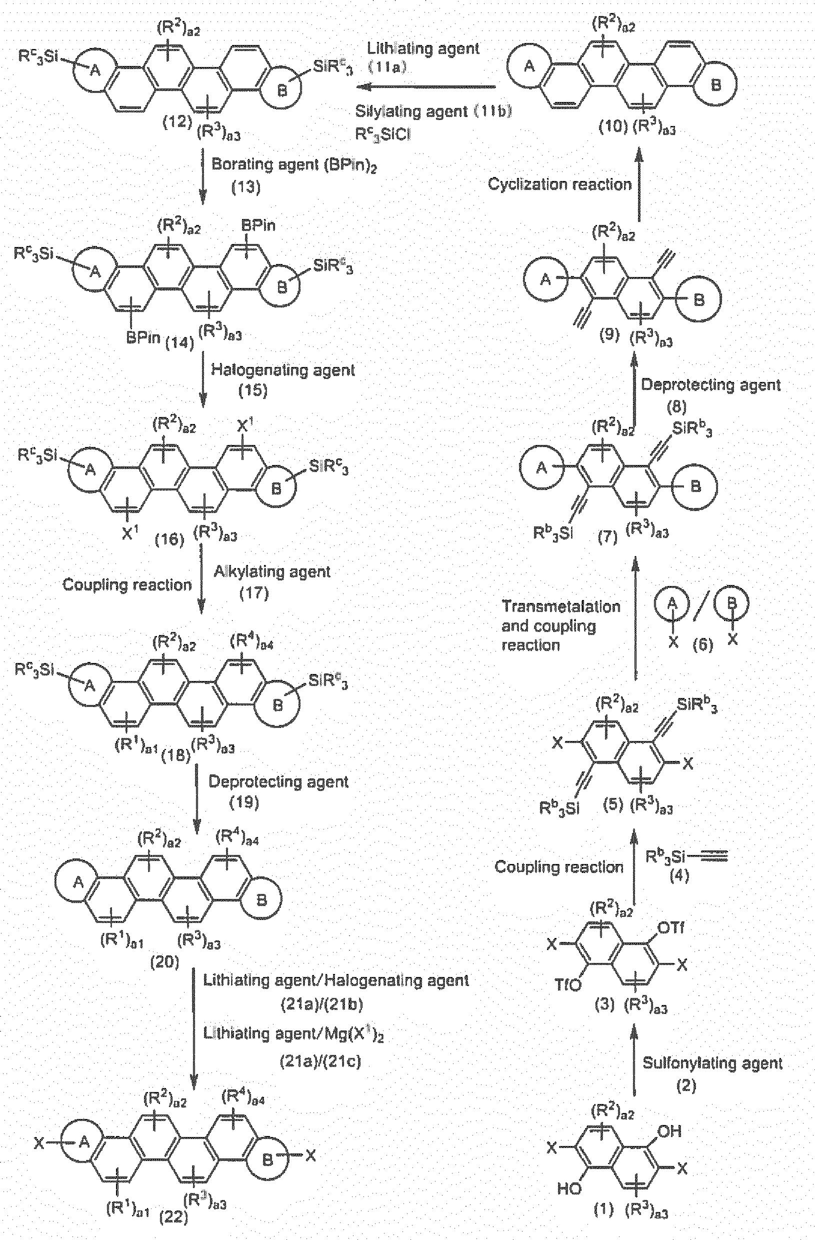

### Synthesis of compound (3) (Sulfonylation of hydroxyl group)

A compound (1) (a dihalodihydroxyarene) is allowed to react with a sulfonylating agent (2) to produce a compound (3) in which hydroxyl groups are protected with protecting groups. Incidentally, in the compound (1), X represents a halogen atom (such as chlorine, bromine, or iodine atom), and R², R³, a2 and a3 have the same meanings as defined above.

In this example, 2,6-dibromonaphthalene-1,5-diol is used as the compound (1), trifluoromethanesulfonic anhydride is used as the sulfonylating agent (2), and the compound (3) having a protecting group, trifluoromethanesulfonyl group (triflate group Tf), introduced thereto (2,6-dibromonaphthalene-1,5-ditrifluoromethanesulfonic acid ester) is produced.

The sulfonylating agent (2) may include a conventional protecting agent for hydroxyl group, for example, an alkanesulfonyl halide, an alkanesulfonic anhydride, a haloalkanesulfonyl halide, and a haloalkanesulfonic acid or a reactive derivative thereof (such as trifluoromethanesulfonyl chloride, trifluoromethanesulfonic acid, or trifluoromethanesulfonic anhydride). A preferred sulfonylating agent includes a haloalkanesulfonic acid or an acid anhydride thereof that can acylate a phenolic hydroxyl group and improve a leaving property of an ester group. The amount to be used of the sulfonylating agent (2) may be about 1 to 3 equivalents relative to the compound (1) .

The reaction can be carried out in the presence of a base. The base may include a tertiary amine, for example, a trialkylamine such as triethylamine, and an aromatic amine such as pyridine. These bases may be used alone or in combination. The amount to be used of the base may be about 2 to 10 equivalents (for example, about 3 to 5 equivalents) relative to the compound (1).

The reaction may be carried out in a solvent inert to the reaction. As the solvent, there may be used the same organic solvent as that for the above-mentioned coupling reaction, for example, an aromatic hydrocarbon compound and a halogenated hydrocarbon compound.

The reaction can be carried out under an inert atmosphere at a temperature of about -20°C to 30°C (usually, about 0°C to a room temperature) for a reaction time of about 1 to 24 hours.

### Synthesis of compound (5) (Introduction of ethynyl group and protecting group)

The produced compound (3) is allowed to react with an alkyne compound (R^{b}₃Si-≡: R^{b} represents an alkyl group) (4) to give a compound (5) having ethynyls introduced thereto. In this example, an alkyne compound (trimethylsilylacetylene) having a protecting group (trimethylsilyl group) is used as the compound (4), and 2,6-dibromo-1,5-di(2-trimethylsilylethynyl) naphthalene as the compound (5) is produced.

The compound (4) may include a compound having an ethynyl group, for example, an alkylsilylacetylene, e.g., a trialkylsilylacetylene such as trimethylsilylacetylene, triethylsilylacetylene, triisopropylsilylacetylene, tributylsilylacetylene, or triisobutylsilylacetylene.

The amount to be used of the compound (4) may be about 1.5 to 5 mol (preferably about 2 to 3 mol) relative to the compound (3). The reaction can be carried out in the presence of a palladium catalyst (or a palladium complex) in accordance with a Sonogashira coupling reaction. The palladium catalyst may be, for example, a palladium halide (palladium chloride) and a palladium complex (such as an acetylacetonato complex, a phosphine complex, or a bis (diphenylphosphino) ferrocene complex). The amount to be used of the palladium catalyst may be about 0.1 to 10% by mol relative to the compound (3). Moreover, the palladium catalyst may be used in combination with a copper compound. Examples of the copper compound may include a copper halide (such as copper iodide or copper bromide) and a copper complex. The amount to be used of the copper compound may be about 1 to 50% by mol relative to the compound (3).

The reaction can be carried out in the presence of a base. The base may be an amine compound, for example, diethylamine, triethylamine, diisopropylamine, pyridine, and morpholine. It is often the case that the amount to be used of the base is an excess molar amount relative to the protecting group of the compound (3).

The reaction may be carried out in a solvent inert to the reaction. As the solvent, there may be used the same organic solvent as that for the above-mentioned coupling reaction, for example, a halogenated hydrocarbon compound, an amide compound, and an ether compound.

The reaction can be carried out under an inert atmosphere at a temperature of about -20°C to 30°C (usually about 0°C to a room temperature) for a reaction time of about 1 to 24 hours.

After completion of the reaction, the reaction mixture can be subjected to the next reaction with or without separation and purification.

### Synthesis of compound (7) (Introduction of ring A and ring B)

The compound (5) can be allowed to react with a compound (6) to prepare a compound (7). For the reaction, a transmetalation reaction can be utilized. For example, the compound (5) may be allowed to react with a lithiating agent to form a lithiated product (a lithiation step), the lithiated product may be allowed to react with a zinc halide to form a transmetalated product (a transmetalation step), and the transmetalated product may be allowed to react with the compound (6) (such as bromothiophene) in the presence of a palladium catalyst and a phosphine ligand (a coupling step) to give the compound (7). In this example, the compound (5) is allowed to react with n-butyllithium to form a lithiated product, the lithiated product is allowed to react with zinc chloride, and the resulting product is allowed to react with the compound (6) in the presence of a palladium catalyst (tris(dibenzylideneacetone)dipalladium(0) chloroform complex (Pd₂(dba)₃·CH₃Cl)) and 2-dicyclohexylchlorophosphino-2',6'-dimethoxybiphenyl (SPos) to give the compound (7).

The lithiating agent may include an alkyllithium, for example, a C₁₋₆alkyllithium such as n-butyllithium, s-butyllithium, or t-butyllithium. The amount to be used of the alkyllithium may be about 1.5 to 5 equivalents (for example, about 2 to 2.5 equivalents) relative to the compound (5). For the reaction (the lithiation step), there may be used an inert solvent, for example, the same organic solvent as that for the above-mentioned coupling reaction, such as an amide compound or an ether compound.

The reaction (the lithiation step) can be carried out under an inert atmosphere at a temperature of about -100°C to 30°C (usually, about -80°C to 0°C) for a reaction time of about 5 minutes to 12 hours.

Examples of the zinc halide may include zinc chloride and zinc bromide. The amount to be used of the zinc halide is substantially the same as that of the alkyllithium. For the reaction (the transmetalation step), there may be used the same solvent as that for the reaction (the lithiation step) with the alkyllithium.

The reaction (the transmetalation step) can be carried out under an inert atmosphere at a temperature of about -50°C to 30°C (usually about -20°C to 20°C) for a reaction time of about 10 minutes to 10 hours.

In the compound (6), X represents a halogen atom (such as chlorine, bromine or iodine atom), and the ring A and the ring B have the same meanings as defined above. The compound (6) may include a compound having a halogen atom and corresponding to the ring A or the ring B, for example, a heterocyclic ring compound having a halogen atom (such as bromothiophene) or an arene compound having a halogen atom (such as bromobenzene).

The amount to be used of the compound (6) may be, for example, about 1.5 to 5 equivalents (e.g., about 2 to 3 equivalents) relative to the compound (5).

The palladium catalyst may include the catalyst as described above, for example, palladium chloride, palladium (acetylacetonate) complex, tris(dibenzylideneacetone)dipalladium(0) chloroform complex (Pd₂(dba)₃·CH₃Cl), and tetrakis(triphenylphosphine)palladium(0) complex. Examples of the ligand may include a phosphine ligand (such as triphenylphosphine, or SPos mentioned above) and a bipyridyl ligand. The amount to be used of the palladium catalyst may be about 0.1 to 10% by mol (for example, about 1 to 5% by mol) relative to the compound (6). Moreover, the amount to be used of the ligand may be about 1 to 50% by mol (for example, about 5 to 20% by mol) relative to the compound (6).

The reaction (the coupling step) can be carried out in an inert solvent. As the solvent, there may be used the same solvent as that for the reaction (the lithiation step) with an alkyllithium.

The reaction (the coupling step) can be carried out under an inert atmosphere at a temperature of about 10°C to 100°C (for example, about 30°C to 70°C) for a time of about 1 to 12 hours.

### Synthesis of compound (9) (Deprotection)

A compound (9) can be prepared by removing the protecting group of the compound (7) with a deprotecting agent (8). For the deprotection reaction, there may be used a conventional deprotecting agent such as an acid or a base, for example, an alkali metal carbonate such as potassium carbonate and a fluoride ion such as tetrabutylammonium fluoride (TBAF). The amount to be used of the deprotecting agent (8) may be about 0.1 to 1 equivalent relative to the compound (7).

The reaction may be carried out in an inert solvent. As the solvent, there may be used, for example, an alcohol compound such as methanol, and the same solvent as that for the reaction (the lithiation step) with the alkyllithium.

The reaction can be carried out under an inert atmosphere at a temperature of about 0°C to 70°C (usually a room temperature of about 20 to 25°C) for a reaction time of about 1 to 36 hours.

### Synthesis of compound (10) (Cyclization)

The compound (9) can be subjected to a cyclization reaction to prepare a compound (10). In this example, the compound (9) is coupled using platinum chloride to form a fused ring.

In a cyclization reaction of an alkyne, there may be used a conventional Lewis acid activating an alkyne moiety, for example, platinum, indium, gallium, gold, palladium, or other catalysts. Examples of the catalyst may include platinum(II) chloride, indium(III) chloride, gallium(III) chloride, gold(III) chloride, palladium(II) chloride, palladium(II) acetate, palladium (acetylacetonate) complex, tris(dibenzylideneacetone)dipalladium(0) chloroform complex (Pd₂(dba)₃·CH₃Cl), and tetrakis(triphenylphosphine)palladium(0) complex. The amount to be used of the Lewis acid catalyst may be about 1 to 50% by mol (for example, about 5 to 40% by mol) equivalents relative to the compound (9).

The reaction may be carried out in an inert solvent. As the solvent, there may be used, for example, the same solvent as the solvent (e.g., an amide compound) for the reaction (the lithiation step) with an alkyllithium.

The reaction can be carried out under an inert atmosphere at a temperature of about 30 to 120°C (for example, about 50 to 100°C) for a time of about 1 to 36 hours.

### Synthesis of compound (12)

A specific site of each of the ring A and the ring B in the compound (10) is protected with a silyl group (-SiR^{c}₃) by lithiating the specific site with a lithiating agent (11a) and silylating the lithium with a silylating agent (R^{c}₃SiCl: R^{c} represents an alkyl group) (11b). In this example, lithium 2,2,6,6-tetramethylpiperidide (LiTMP) is used as the lithiating agent, triisopropylsilyl chloride (TIPSCl) is used as the silylating agent, and an alkylsilyl group (-SiR^{c}₃) is introduced at the specific site of each of the ring A and the ring B.

The lithiating agent (11a) may include the above-mentioned alkyllithium, a lithium amide reagent that is a lithiation product of a secondary amine, such as the above-mentioned LiTMP or LHMDS (Lithium hexamethyldisilazide), or other agents. The amount to be used of the lithiating agent may be about 1 to 5 equivalents (for example, about 1.5 to 3 equivalents) relative to the compound (10).

For the reaction, there may be used an inert solvent, for example, the same organic solvent as that for the coupling reaction, such as an amide compound or an ether compound. The reaction can be carried out under an inert atmosphere at a temperature of about -100°C to 30°C (usually about -80°C to 0°C) for a reaction time of about 1 to 12 hours.

The silylating agent (11b) may include, for example, a tri-straight-chain or branched-chain C₁₋₆alkylsilyl halide such as a trimethylsilyl halide, a triethylsilyl halide, a tributylsilyl halide, or a triisobutylsilyl halide. The amount to be used of the protecting agent may be about 1 to 5 equivalents (for example, about 1.5 to 4 equivalents) relative to the compound (10).

The reaction can be carried out in the same organic solvent as that for the above-mentioned lithiation reaction under an inert atmosphere at a temperature of about -20°C to 50°C (for example, about 10 to 30°C) for a reaction time of about 1 to 24 hours.

### Synthesis of compound (14)

The compound (12) is borylated with a borating agent or boron compound (13) to prepare a compound (14). In this example, a specific site of each of the benzene ring adjacent to the ring A and the benzene ring adjacent to the ring B is borylated with 4,4,4',4',5,5,5',5'-octamethyl-2,2'-bis-1,3,2-dioxaboronate[(BPin)₂] in the presence of an iridium catalyst (bis(1,5-cyclooctadiene)di-µ-methoxydiiridium(I) complex: Ir(OMe)(COD)₂) and 4,4'-di-t-butyl-2,2'-bipyridyl(dibpy).

The borylation of the compound (12) may include a conventional borylation method using a catalyst such as an iridium catalyst, a rhenium catalyst, or a rhodium catalyst, for example, a method using an iridium catalyst and a ligand such as a bipyridyl ligand, a diimine ligand, or a phosphine ligand (e.g., triphenylphosphine). The amount to be used of the catalyst such as an iridium catalyst may be about 0.1 to 10% by mol (for example, about 0.5 to 3% by mol) relative to the compound (12). The ligand such as a bipyridyl ligand may be used in a molar amount of about 1.5 to 5 times the molar amount of the catalyst.

As the borating agent or boron compound (13), there may be used a compound that can form a boronic acid ester, for example, (BPin)₂ and a conventional compound, e.g., diborane acid, pinacolborane, and bis(pinacolato)diborane. The amount to be used of the boron compound (13) may be about 1.5 to 5 equivalents (for example, about 2 to 3 equivalents) relative to the compound (12).

The reaction can be carried out in an inert solvent such as the above-mentioned organic solvent or alicyclic hydrocarbon compound (such as cyclohexane) under an inert atmosphere at a temperature of about 30 to 120°C (for example, about 50 to 100°C) for a reaction time of about 1 to 36 hours.

### Synthesis of compound (16)

The compound (14) can be allowed to react with a halogenating agent (15) to prepare a compound (16) having a halogen atom introduced thereto. In this example, the compound (14) is allowed to react with copper bromide (II) to give the compound (16). The halogenating agent (15) may include a copper halide Cu(X¹)2. Examples of the halogen atom X¹ in the copper halide Cu(X¹)2 may include chlorine, bromine, or iodine atom. As examples of the copper halide, there may be mentioned copper chloride and copper iodide in addition to copper bromide(II). The amount to be used of the halogenating agent (15) such as a copper halide may be about 2 to 10 equivalents (for example, about 3 to 8 equivalents) relative to the compound (14) .

The reaction can be carried out in a solvent inert to the reaction (for example, a mixed solution of a water-soluble solvent (e.g., a cyclic ether compound, an amide compound such as N-methylpyrrolidone, and an alcohol compound such as methanol) and water) under an inert atmosphere at a temperature of about 30 to 120°C (for example, about 50 to 100°C) for a reaction time of about 5 to 48 hours.

### Synthesis of compound (18)

The compound (16) can be allowed to react with an alkylating agent (17) in the presence of a catalyst using a Negishi coupling reaction to prepare a compound (18). In this example, the compound (16) and a zinc reagent (an alkylzinc halide lithium chloride, e.g., R¹-ZnCl LiCl and/or R⁴-ZnCl LiCl (R¹ and R⁴ represent an alkyl group)) as the alkylating agent (17) are subjected to a cross-coupling reaction in the presence of a palladium catalyst (1,1'-bis(diphenylphosphino)ferrocene] dichloropalladium(II) dichloromethane complex (PdCl₂(dppf)CH₂Cl₂) to introduce alkyl groups to the compound (16).

As the alkylating agent (17), for example, there may be used a conventional alkylating agent, e.g., an alkylmetal such as a Grignard reagent, an alkylzinc halide, a dialkylzinc, or a lithium zincate or a magnesium zincate (M⁺R¹₃Zn⁻ and/or M⁺R⁴₃Zn⁻ (M represents lithium or magnesium, R¹ and R⁴ represent an alkyl group)). These alkylating agents may be used alone or in combination. As the alkylating agent, the zinc reagent (a lithium zincate or a magnesium zincate) is used in many cases.

The zinc reagent may be produced, for example, by a reaction of an alkylmagnesium halide (B1), a zinc compound (B2) (e.g., a zinc halide such as zinc chloride), and a lithium compound (B3) (e.g., a halogenated lithium such as lithium chloride) . As the alkylmagnesium halide (B1), there may be used an alkylmagnesium halide (a chloride, a bromide, an iodide) corresponding to R¹ and R⁴. The amount to be used of the alkylmagnesium halide (B1) may be, for example, about 1.5 to 10 equivalents (for example, about 2 to 5 equivalents) relative to the compound (16). Each of the zinc compound (B2) and the lithium compound (B3) may be, for example, used in a molar amount of about 0.8 to 1.2 times the molar amount of the alkylmagnesium halide (B1). The amount to be used of the compound (17) as the zinc reagent may be about 1.5 to 5 equivalents (for example, about 2 to 3 equivalents) relative to the compound (16).

The zinc reagent can be prepared, for example, by conducting the reaction in a solvent inert to the reaction under an inert atmosphere at a temperature of about 10 to 70°C (for example, a room temperature of about 20 to 25°C) for a time of about 10 minutes to 12 hours.

The palladium catalyst may include the above-mentioned catalyst, and the palladium catalyst as exemplified in the coupling reaction. Incidentally, as the ligand, a phosphine ligand (triphenylphosphine) or other ligands may be used in combination. The amount to be used of the palladium catalyst may be, for example, about 1 to 50% by mol (for example, about 5 to 25% by mol) relative to the compound (16).

The reaction with the zinc reagent can be carried out in a solvent inert to the reaction (for example, a cyclic ether compound) under an inert atmosphere at a temperature of about 30 to 120°C (for example, about 50 to 100°C) for a reaction time of about 1 to 24 hours.

### Synthesis of compound (20)

The compound (20) represented by the formula (Ia) in which X corresponds to a hydrogen atom can be prepared by subjecting the compound (18) to a deprotection reaction. In the same manner as the synthesis of the compound (9), for the deprotection reaction, there may be used a conventional deprotecting agent (19), for example, an alkali metal carbonate such as potassium carbonate and a fluoride ion such as tetrabutylammonium fluoride (TBAF) . The amount to be used of the deprotecting agent may be about 1 to 10 equivalents (for example, about 2 to 5 equivalents) relative to the compound (18).

The deprotection reaction can be carried out in a solvent inert to the reaction (for example, a cyclic ether compound) under an inert atmosphere at a temperature of about -20°C to 50°C (for example, about -10°C to 30°C) for a reaction time of about 10 minutes to 12 hours.

### Synthesis of compound (22)

The compound (22) represented by the formula (Ia) in which X is a lithium atom can be prepared by lithiating the compound (20) with a lithiating agent (21a). The compound (22) represented by the formula (Ia) in which X is a halogen atom can be prepared by allowing the lithiated compound to react with a halogenating agent (21b) .

As the lithiating agent (21a), there may be used the same lithiating agent as described above. The amount to be used of the lithiating agent may be about 1.5 to 10 equivalents (for example, about 2 to 5 equivalents) relative to the compound (20). The lithiation reaction can be carried out in the same manner as described above.

Incidentally, the compound (22) in which X is a lithium atom may not be separable from the reaction system due to high instability to water and/or oxygen. However, after the reaction with the lithiating agent (21a), the resulting lithiated compound is allowed to react with a deuterating agent (heavy water) to form a deuterated compound in which the lithium atom has been replaced with deuterium; from this fact, it can be confirmed that the compound (22) is lithiated. Accordingly, the compound (22) in which X is a lithium atom can be subjected to a subsequent reaction as an intermediate without separation from the reaction system.

As the halogenating agent (21b), there may be used a conventional halogen compound, such as chlorine, bromine, or iodine. The amount to be used of the halogenating agent is substantially the same as that of the lithiating agent. The halogenation reaction can be carried out in a solvent inert to the reaction (for example, a cyclic ether compound) under an inert atmosphere at a temperature of about -10°C to 50°C (for example, about 0°C to 30°C) for about 1 to 24 hours.

The compound (22) represented by the formula (Ia) in which X is -MgX¹ (a halomagnesio group) can be prepared in the same manner as the halogenation reaction except that a magnesium halide Mg(X¹)₂ (21c), such as magnesium bromide or magnesium chloride, is used instead of the halogenating agent (21b).

Incidentally, in each of the reaction steps as described above, after completion of the reaction, a specific compound may be separated and purified by a conventional separation and purification method, for example, concentration, crystallization or precipitation, recrystallization, extraction, washing, and chromatography and then subjected to a subsequent reaction; or may be subjected to a subsequent reaction without separation or purification of the specific compound from the reaction mixture.

The reaction scheme described above explains the production of the compound represented by the formula (Ia) in which n = 2. When a benzene compound is used instead of the naphthalene compound as the compound (1) (in other words, when a compound in which two benzene rings between the ring A and the ring B are ortho-fused is used as the compound (10)), the compound in which n = 1 can be prepared; when a phenanthrene compound is used, a compound in which n = 3 can be prepared; and when a benzo[a]phenanthrene compound (a chrysene compound), a benzo[a]chrysene compound (a picene compound), and a benzo[c]picene compound are used, compounds in which n = 4 to 6 can be prepared. Moreover, the compound represented by the formula (Ia) in which n = 0 can be prepared by using a compound in which two benzene rings between the ring A and the ring B are ortho-fused instead of the compound represented by the formula (10).

Incidentally, the compound represented by the formula (Ia) in which the ring A and the ring B are a benzene ring, and X is a hydrogen atom may be a known fused polycyclic hydrocarbon (for example, phenanthrene, benzo[a]phenanthrene (chrysene), benzo[a]chrysene (picene) and benzo[c]picene) or may be prepared by a conventional method such as a cyclization reaction and a hydrogenation reaction, for example, with reference to Example 1 of Patent Document 4.

Moreover, for the reaction, there may be used various reactions such as a halogenation reaction, a lithiation reaction, a silylation reaction, a transmetalation reaction, a coupling reaction (various coupling reactions such as a Negishi coupling, a Suzuki coupling, a Suzuki-Miyaura coupling, a Sonogashira coupling, and a Migita-Kosugi-Stille coupling) or a Heck reaction, a Grignard reaction, introduction and removal of a protecting group, and oxidation and reduction reactions. In the coupling reaction, using a conventional catalyst (a catalyst such as a palladium catalyst, a nickel catalyst, or a copper catalyst), an aryl halide can be allowed to react with an organic zinc, an organic tin, an alkene compound, an alkyne compound, an organic boron, an organic amine, or other compounds, or cyclization can also be carried out.

### [Application of organic polymer]

In an embodiment of the present invention, the organic polymer shows a high carrier mobility and has semiconductor characteristics. Further, the organic polymer having an alkyl chain or other groups introduced thereto has a high solubility in an organic solvent. Accordingly, as described above, the composition containing the organic polymer and the organic solvent is suitable as a coating agent or composition for forming an organic semiconductor.

The organic semiconductor may be formed by applying the above-mentioned composition to a base material or substrate (such as a glass plate, a silicon wafer, or a plastic film) and drying the coated layer to remove the solvent. The applying method is not particularly limited to a specific one, and there may be used a conventional applying method, for example, air knife coating, roll coating, gravure coating, blade coating, dip coating, spraying, spin coating, screen printing, and ink jet printing. The spin coating or the ink jet printing is usually utilized in many cases.

The organic semiconductor may have a thickness of, for example, about 1 to 5000 nm, preferably about 30 to 1000 nm, and more preferably about 50 to 500 nm, depending on purposes of the organic semiconductor. In an embodiment of the present invention, even if the thickness of the organic semiconductor is thin, the thin film has not only a high mechanical strength but also a uniformity and a homogeneity, particularly a high surface smoothness.

In an embodiment of the present invention, the organic semiconductor may be an n-type semiconductor or a p-type semiconductor or may be an intrinsic semiconductor. In an embodiment of the present invention, since the organic polymer (and the organic semiconductor) has a high electron and/or hole mobility (carrier mobility), the organic polymer (and the organic semiconductor) is suitable as a material for an electronic device, e.g., a switching element, a rectifier element, and a transistor. Such an organic thin-film transistor comprises a gate electrode layer, a gate insulating layer, a source/drain electrode layer, and an organic semiconductor layer. According to the laminated structure of these layers, the organic thin-film transistor can be classified into a top-gate transistor and a bottom-gate transistor (a top-contact transistor, a bottom-contact transistor) . For example, a top-contact field effect transistor can be produced by forming an organic semiconductor film on a gate electrode (e.g., a p-type silicon wafer having an oxide layer formed thereon) and forming source-drain electrodes (gold electrodes) on the organic semiconductor film.

Moreover, in an embodiment of the present invention, the organic polymer (and the organic semiconductor) has a high carrier mobility by light absorption (a photoelectric conversion efficiency) and has a photoelectric conversion capacity. Thus, in an embodiment of the present invention, the organic semiconductor is also suitable as a material for a photoelectric conversion device or a photoelectric conversion element (such as a solar cell element or an organic electroluminescent (EL) element) or a rectifier element (a diode). A solar cell as a representative photoelectric conversion device may have a laminated structure comprising a pn-junction semiconductor and a surface electrode laminated thereon, for example, a laminated structure comprising a p-type silicon semiconductor, an organic semiconductor layer laminated on the p-type silicon semiconductor, and a transparent electrode (such as an ITO electrode) laminated on the organic semiconductor layer. Moreover, the organic EL element may have a structure comprising a transparent electrode (such as an ITO electrode), a light-emitting layer containing an organic polymer (a light-emitting polymer) formed on the transparent electrode, and an electrode (such as a metal electrode) laminated on the light-emitting layer. If necessary, an electron-transport material and/or a hole-transport material may be dispersed in the light-emitting layer.

### EXAMPLES

The following examples are intended to describe this invention in further detail and should by no means be interpreted as defining the scope of the invention.

### Synthesis Example 1

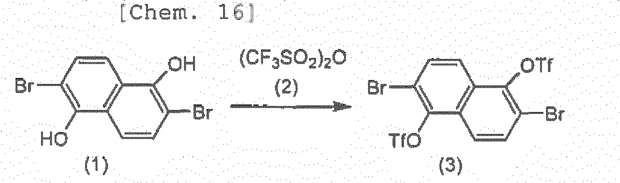

Under an argon atmosphere, an orange-colored suspension of 2,6-dibromonaphthalene-1,5-diol (1) (100 g, 315 mmol)/dichloromethane (700 mL)/pyridine (101 mL, 126 mmol) was cooled to 0°C. While stirring, a solution of trifluoromethanesulfonic anhydride (2) (134 mL, 818 mmol) /dichloromethane (100 mL) was added dropwise to the suspension, and then the resulting dark red suspension was stirred at a room temperature for one hour and a half. To the reaction mixture was added water, and the resulting organic layer was extracted with chloroform. The extract was filtered through silica gel, and then the filtrate was concentrated under a reduced pressure. The resulting crude product was washed with acetone to give an object compound (3) (2,6-dibromonaphthalene-1,5-ditrifluoromethanesulfonic acid ester) as a white solid (110 g, 60% yield).
NMR: ¹H-NMR (400 MHz, CDCl₃) : δ (ppm) 7.88 (d, 2H, J = 8.8 Hz, ArH), 8.02 (d, 2H, J = 8.8 Hz, ArH).

### Synthesis Example 2

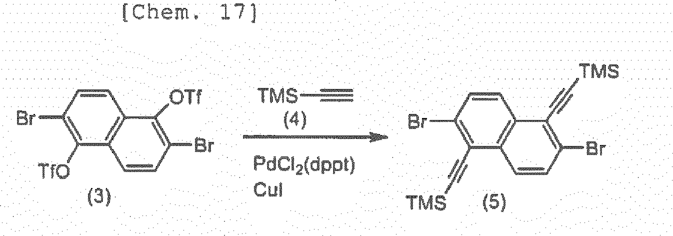

Under an argon atmosphere, argon was blown in a brown solution of the compound (3) (1 g, 1.7 mmol)/N,N-dimethylformamide (7 mL)/diisopropylamine (8.6 mL) for 15 minutes. Thereafter, copper iodide(I) (32.7 mg, 0.17 mmol), [1,1'-bis(diphenylphosphino) ferrocene]dichloropalladium(II) dichloromethane complex (70.2 mg, 0.086 mmol), and trimethylsilylacetylene (TMS-≡) (4) (0.5 mL, 3.6 mmol) were added thereto while stirring at a room temperature, and then the resulting black suspension was stirred at a room temperature for 12 hours . The reaction mixture was diluted with chloroform, and then the diluted mixture was filtered through silica gel. The filtrate was concentrated under a reduced pressure, and the resulting crude product was recrystallized in hexane to give an object compound (5) (2,6-dibromo-1,5-di(2-trimethylsilylethynyl)naphthalene) as a light yellow solid (0.79 g, 86% yield).
NMR: ¹H-NMR (400 MHz, CDCl₃) : δ (ppm) 0.35 (s, 18H, Si(CH₃)₃), 7.71 (d, 2H, J = 8.8 Hz, ArH), 8.14 (d, 2H, J = 8.8 Hz, ArH).

### Synthesis Example 3

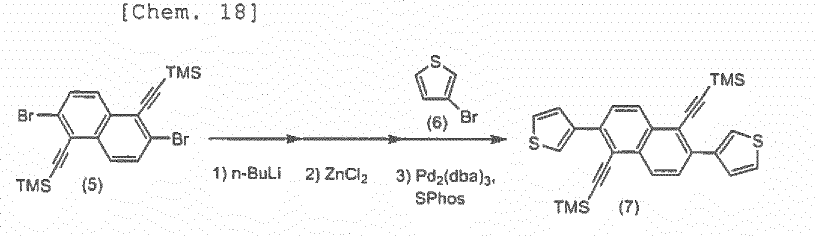

Under an argon atmosphere, while stirring a yellow suspension of the compound (5) (40.5 g, 84.7 mmol)/tetrahydrofuran (320 mL) at -78°C, a 1.6 M n-butyllithium-hexane solution (111 mL, 177.8 mmol) was added dropwise to the suspension. The resulting ocher suspension was stirred at -78°C for another 30 minutes, and then a 1.0 M zinc chloride-tetrahydrofuran solution (178 mL, 177.8 mmol) was added thereto. The resulting mixture was stirred at 0°C for one hour. To the resulting yellow suspension was added a compound (6) (3-bromothiophene) (20 mL, 212 mmol), tris(dibenzylideneacetone)dipalladium(0) chloroform complex (Pd₂(dba)₃·CH₃Cl) (2.2 g, 2.1 mmol), and 2-dicyclohexylphosphino-2',6'-dimethoxybiphenyl (SPos) (3.5 g, 8.5 mmol) at 0°C, and then the resulting mixture was stirred at 50°C for 5 hours. To the reaction mixture was added water, and the resulting organic layer was extracted with chloroform. The extract was concentrated under a reduced pressure, and the resulting crude product was purified by silica gel column chromatography (hexane:dichloromethane = 100:0 to 80:20) to give an object compound (7) (2,6-bis(thiophen-3-yl)-1,5-di(2-trimethylsilylethynyl)naphthalene) as a light yellow solid (24 g, 47% yield).
NMR: ¹H-NMR (400MHz, CDCl₃): δ (ppm) 0.29 (s, 18H, Si(CH₃)₃), 7.40 (m, 2H, ArH of thienyl group), 7.63 (m, 2H, ArH of thienyl group), 7.71 (d, 2H, J = 8.4 Hz, ArH of naphthalene ring), 7.83 (m, 2H, ArH of thienyl group), 8.45 (d, 2H, J = 8.4 Hz, ArH of naphthalene ring).

### Synthesis Example 4

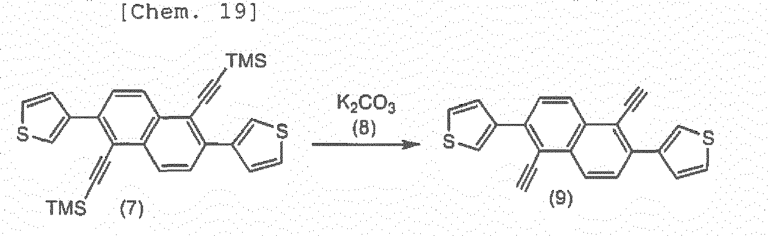

Under an argon atmosphere, while stirring a yellow suspension of the compound (7) (24 g, 70.5 mmol) /methanol (150 mL) /dichloromethane (300 mL) at a room temperature, potassium carbonate (3.9 g, 28.2 mmol) as a deprotecting agent (8) was added to the suspension. After the resulting mixture was stirred at a room temperature for 22 hours, water was added to the reaction mixture, and the resulting organic layer (or phase) was extracted with chloroform. The extract was concentrated under a reduced pressure to give an object compound (9) (2,6-bis(thiophen-3-yl)-1,5-diethynylnaphthalene) as a light brown solid (16.9 g, >99% yield).
NMR: ¹H-NMR (400 MHz, CDCl₃) : δ (ppm) 3.63 (s, 2H, H of terminal alkyne (ethynyl group)), 7.42 (m, 2H, ArH of thienyl group), 7.61 (m, 2H, ArH of thienyl group), 7.71 (d, 2H, J = 8.4 Hz, ArH of naphthalene ring), 7.81 (m, 2H, ArH of thienyl group), 8.52 (d, 2H, J = 8.4 Hz, ArH of naphthalene ring).

### Synthesis Example 5

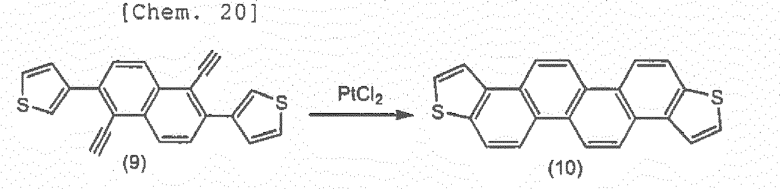

Under an argon atmosphere, while stirring a brown suspension of the compound (9) (16.9 g, 49.6 mmol)/N,N-dimethylformamide (510 mL) at a room temperature, platinum(II) chloride (2.7 g, 9.9 mmol) was added to the suspension. After the resulting mixture was stirred at 80°C for 16 hours, the reaction mixture was cooled to a room temperature and was filtered to give an object compound (10) as a crude product (16.9 g).
NMR: ¹H-NMR (400 MHz, TCE-d₂): δ (ppm) 7.67 (d, 2H, J = 5.6 Hz, ArH), 8.11 (d, 2H, J = 5.6 Hz, ArH), 8.14 (d, 2H, J = 9.2 Hz, ArH), 8.56 (d, 2H, J = 9.2 Hz, ArH), 8.75 (d, 2H, J = 9.2 Hz, ArH), 8.91 (d, 2H, J = 9.2 Hz, ArH) .

### Synthesis Example 6

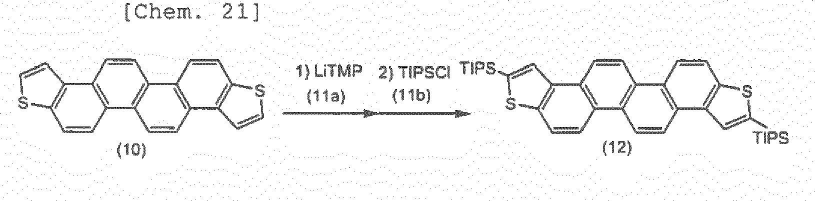

Under an argon atmosphere, while stirring a dark yellow suspension of the compound (10) (12 g, 35.2 mmol)/tetrahydrofuran (360 mL) at -78°C, a 0.5 M lithium 2,2,6,6-tetramethylpiperidide (LiTMP)-tetrahydrofuran solution (170 mL, 84.6 mmol) as a lithiating agent (11a) was added dropwise to the suspension. After the resulting ocher suspension was further stirred at -50°C for 5 hours, triisopropylsilyl chloride (TIPSCl) (21 mL, 98.7 mmol) as a silylating agent (11b) was added to the suspension. The resulting mixture was stirred for 12 hours while naturally rise to a room temperature. To the resulting brown suspension was added water, the resulting mixture was diluted with methanol, and then the diluted mixture was filtered to give a crude product. The crude product was recrystallized in chloroform-methanol mixed solvent (1:1) to give an object compound (12) as a brown solid (15.4 g, 52% yield over two steps).
NMR: ¹H-NMR (400 MHz, TCE-d₂): δ (ppm) 1.28 (d, 36H, J = 7.2 Hz, Si(CH)(CH₃)₃), 1.54 (m, 6H, Si(CH)(CH₃)₃), 8.19 (d, 2H, J = 9.2 Hz, ArH), 8.30 (s, 2H, ArH of thiophene ring), 8.66 (d, 2H, J = 9.2 Hz, ArH), 8.75 (d, 2H, J = 9.2 Hz, ArH), 8.94 (d, 2H, J = 9.2 Hz, ArH).

### Synthesis Example 7

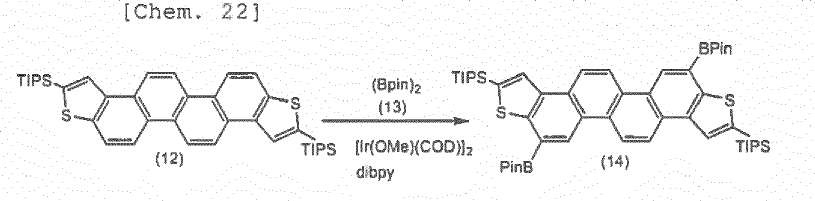

Under an argon atmosphere, while stirring a suspension of the compound (12) (3.0 g, 4.6 mmol)/cyclohexane (60 mL) at a room temperature, bis(1,5-cyclooctadiene)di-µ-methoxydiiridium(I) complex ([Ir(OMe)(COD)]₂) (155 mg, 0.23 mmol), 4,4'-di-tert-butyl-2,2'-bipyridyl (dibpy) (126 mg, 0.47 mmol), and 4,4,4',4',5,5,5',5'-octamethyl-2,2'-bis-1,3,2-dioxaboronate [(BPin)₂] (2.5 g, 9.6 mmol) as a borating agent (13) were added to the suspension. The resulting brown suspension was further stirred at 80°C for 19 hours. After the reaction mixture was diluted with chloroform, the diluted mixture was filtered through celite, and the filtrate was concentrated under a reduced pressure to give a crude product. The crude product was washed with methanol to give an object compound (14) as a yellow solid (3.8 g, 91% yield).
NMR: ¹H-NMR (400 MHz, TCE-d₂): δ (ppm) 1.26 (d, 36H, J = 7.6 Hz, Si(CH)(CH₃)₃), 1.44 (s, 24H), 1.54 (m, 6H, Si(CH)(CH₃)₃), 8.28 (s, 2H, J = 9.2 Hz), 8.65 (d, 2H, J = 9.2 Hz, ArH), 9.08 (d, 2H, J = 9.2 Hz, ArH), 9.24 (s, 2H, ArH).

### Synthesis Example 8

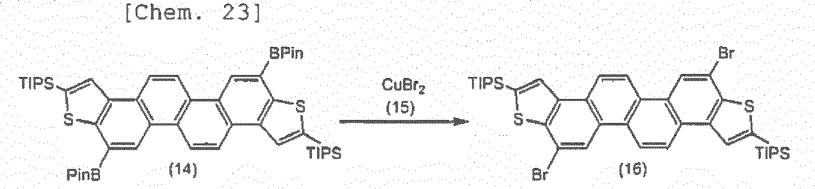

Under an argon atmosphere, while stirring a suspension of the compound (14) (3.8 g, 4.2 mmol)/N-methylpyrrolidone (300 mL)/methanol (100 mL)/water (50 mL) at a room temperature, copper bromide(II) (5.8 g, 26.0 mmol) as a halogenating agent (15) was added to the suspension. The resulting dark green suspension was stirred at 80°C for 34 hours. The reaction mixture was extracted with chloroform, and the extract was concentrated under a reduced pressure. The resulting crude product was washed with methanol to give an object compound (16) as a light pink solid (2.68 g, 79% yield).
NMR: ¹H-NMR (400 MHz, TCE-d₂): δ (ppm) 1.25 (d, 36H, J = 7.2 Hz, Si(CH)(CH₃)₃), 1.52 (m, 6H, Si(CH)(CH₃)₃), 8.35 (s, 2H, ArH), 8.57 (d, 2H, J = 9.2 Hz, ArH), 8.83 (d, 2H, J = 9.2 Hz, ArH), 8.87 (s, 2H, ArH).

### Synthesis Example 9

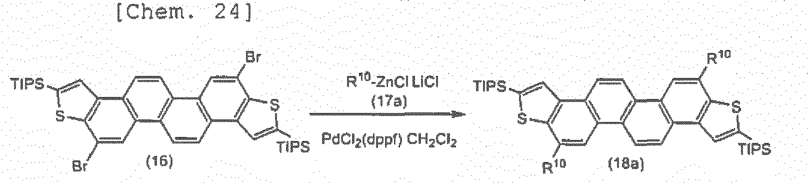

(R¹⁰ represents n-hexadecyl group. The same applies hereinafter.)

Under an argon atmosphere, while stirring a 0.65 M n-hexadecylmagnesium bromide-tetrahydrofuran solution (4.7mL, 3.1 mmol) /tetrahydrofuran (6 mL) solution at 0°C, a 1.0 M zinc chloride(II)-tetrahydrofuran solution (3.2 mL, 3.1 mmol) and a 0.5 M lithium chloride-tetrahydrofuran solution (6.2 mL, 3.1 mmol) were added thereto. Then, the resulting white suspension was stirred at a room temperature for 30 minutes to prepare a clear zinc reagent (alkylzinc chloride lithium chloride: R¹⁰-ZnCl LiCl, wherein R¹⁰ represents n-hexadecyl group.) (compound (17a)).

To the zinc reagent (the compound (17a)) were added the compound (16) (0.96 g, 1.2 mmol) and [1,1'-bis(diphenylphosphino)ferrocene]dichloropalladium(II) dichloromethane complex (PdCl₂(dppf)CH₂Cl₂) (98.6 mg, 0.12 mmol) at a room temperature. The resulting yellow suspension was stirred at 70°C for 11 hours. To the resulting black suspension was added water, the resulting organic layer was extracted with chloroform and was then washed with water. The extract was concentrated under a reduced pressure, and the resulting crude product was purified by silica gel column chromatography (hexane) to give an object compound (18a) as a white solid (778 mg, 56% yield).
NMR: ¹H-NMR (400 MHz, TCE-d₂): δ (ppm) 0.88 (d, 6H, J = 6.8 Hz), 1.2-1.6 (m, 94H), 2.03 (m, 4H), 3.19 (t, 4H, J = 7.6 Hz), 8.29 (s, 2H, ArH), 8.51 (s, 2H, ArH), 8.57 (d, 2H, J = 9.2 Hz, ArH), 8.86 (d, 2H, J = 9.2 Hz, ArH) .

### Synthesis Example 10

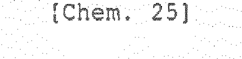

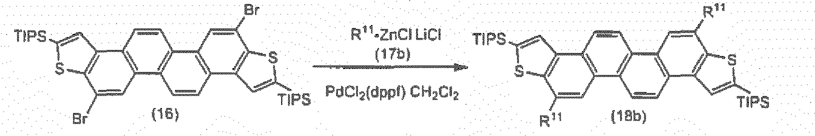

(R¹¹ represents 3-octyltridecyl group. The same applies hereinafter.)

An object compound was obtained in the same manner as Synthesis Example 9 except that 3-octyl-tridecylmagnesium bromide was used instead of n-hexadecylmagnesium bromide in Synthesis Example 9. That is, under an argon atmosphere, while stirring a 0.096 M 3-octyl-tridecylmagnesium bromide-tetrahydrofuran solution (32 mL, 3.1 mmol)/tetrahydrofuran (40 mL) solution at 0°C, a 1.0 M zinc chloride (II)-tetrahydrofuran solution (3.1 mL, 3.1 mmol) and a 0.5 M lithium chloride-tetrahydrofuran solution (6.2 mL, 3.1 mmol) were added thereto. Then, the resulting white suspension was stirred at a room temperature for one hour to prepare a clear zinc reagent (a compound (17b)). To the zinc reagent (the compound (17b)) were added the compound (16) (996 mg, 1.2 mmol) and [1,1'-bis(diphenylphosphino)ferrocene] dichloropalladium(II) dichloromethane complex (101 mg, 0.12 mmol) at a room temperature. The resulting suspension was stirred at 70°C for 14 hours. To the resulting black suspension was added water, the resulting organic layer was extracted with chloroform and was then washed with water. The extract was concentrated under a reduced pressure, and the resulting crude product was purified by silica gel column chromatography (hexane) to give an object compound (18b) as a white solid (1.2 g, 77% yield).
NMR: ¹H-NMR (400 MHz, TCE-d₂): δ (ppm) 0.84-0.92 (m, 12H), 1.16-1.60 (m, 108H), 1.95-2.00 (m, 4H), 3.17 (t, 4H, J = 7.6 Hz), 8.23 (s, 2H, ArH), 8.51 (s, 2H, ArH), 8.56 (d, 2H, J = 9.2 Hz, ArH), 8.86 (d, 2H, J = 9.2 Hz, ArH).

### Synthesis Example 11

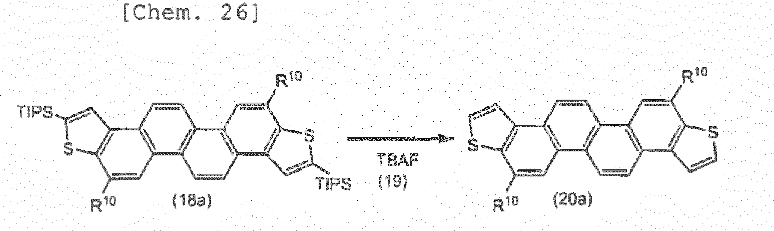

Under an argon atmosphere, while stirring a solution of the compound (18a) (99 mg, 0.09 mmol)/tetrahydrofuran (5 mL) at 0°C, a 1.0 M tetrabutylammonium fluoride (TBAF)-tetrahydrofuran solution (0.27 mL, 0.27 mmol) as a deprotecting agent (19) was added thereto. The resulting white suspension was stirred at a room temperature for one hour. To the reaction mixture was added water, and the resulting mixture was filtered and was then washed with water/methanol to give an object compound (20a) as a white solid (45 mg, 62% yield).
NMR: ¹H-NMR (400 MHz, TCE-d₂): δ (ppm) 0.87 (t, 6H, J = 6.8 Hz), 1.35 (m, 48H), 1.55 (m, 4H), 2.01 (m, 4H), 3.16 (t, 4H, J = 7.6 Hz), 7.65 (d, 2H, J = 5.6 Hz, ArH of thiophene ring), 8.12 (d, 2H, J = 5.6 Hz, ArH of thiophene ring), 8.51 (d, 2H, J = 9.2 Hz, ArH), 8.54 (s, 2H, ArH), 8.86 (d, 2H, J = 9.2 Hz, ArH).

### Synthesis Example 12

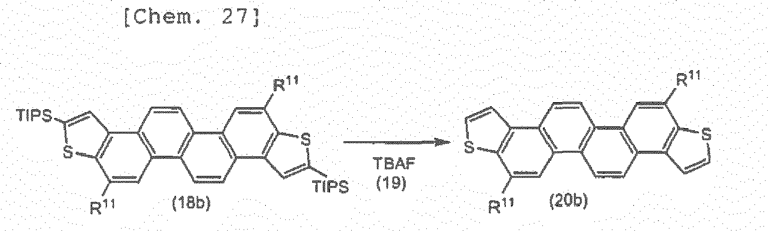

Under an argon atmosphere, while stirring a solution of the compound (18b) (1.1 g, 0.88 mmol)/tetrahydrofuran (50 mL) at 0°C, a 1.0 M tetrabutylammonium fluoride-tetrahydrofuran solution (2.6 mL, 2.6 mmol) as a deprotecting agent (19) was added thereto. After the resulting white suspension was stirred at a room temperature for one hour, water was added thereto. The resulting mixture was filtered and was washed with water/methanol to give an object compound (20b) as a white solid (793 mg, 97% yield).
NMR: ¹H-NMR (400 MHz, TCE-d₂): δ (ppm) 0.84-0.92 (m, 12H), 1.22-1.50 (m, 66H), 1.52-1.60 (m, 2H), 1.92-2.0 (m, 4H), 3.15 (t, 4H, J = 7.6 Hz), 7.65 (d, 2H, J = 5.2 Hz, ArH of thiophene ring), 8.12 (d, 2H, J = 5.2 Hz, ArH of thiophene ring), 8.51 (d, 2H, J = 9.2 Hz, ArH), 8.55 (s, 2H, ArH), 8.86 (d, 2H, J = 9.2 Hz, ArH).

### Synthesis Example 13

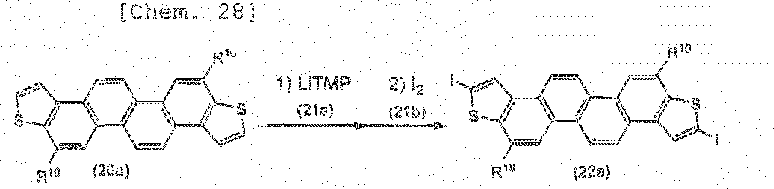

Under an argon atmosphere, while stirring a white suspension of the compound (20a) (411 mg, 0.51 mmol)/tetrahydrofuran (42 mL) at -78°C, a 0.5 M lithium 2,2,6,6-tetramethylpiperidide-tetrahydrofuran solution (2.4 mL, 1.2 mmol) as a lithiating agent (21a) was added dropwise to the suspension. The resulting suspension was further stirred at -50°C for 2 hours, and the temperature of the suspension was then increased to 0°C. To the suspension was added a 0.5 M iodine-tetrahydrofuran solution (3.0 mL, 1.5 mmol) as a halogenating agent (21b) . The resulting red suspension was stirred for 12 hours while naturally rising to a room temperature. Then, to the resulting bright red suspension was added an aqueous solution of sodium thiosulfate, and the resulting organic layer was extracted with chloroform. The extract was concentrated under a reduced pressure, and the resulting crude product was washed with methanol, hexane, and chloroform, and then the washed product was recrystallized (in chloroform) to give an object compound (22a) as a white solid (491 mg, 93% yield).
NMR: ¹H-NMR (400 MHz, TCE-d₂): δ (ppm) 0.88 (t, 6H, J = 6.4 Hz), 1.20-1.45 (m, 48H), 1.45-1.55 (m, 4H), 1.90-2.0 (m, 4H), 3.08 (t, 4H, J = 7.6 Hz), 8.28 (s, 2H, ArH of thiophene ring), 8.39 (d, 2H, J = 8.8 Hz, ArH), 8.46 (s, 2H, ArH of thiophene ring), 8.81 (d, 2H, J = 9.2 Hz, ArH).

### Synthesis Example 14

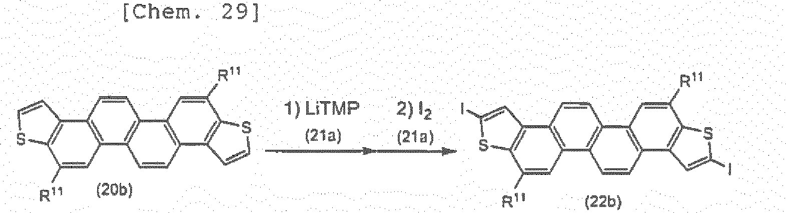

Under an argon atmosphere, while stirring a clear solution of the compound (20b) (200 mg, 0.22 mmol)/tetrahydrofuran (20 mL) at -78°C, a 0.5 M lithium 2,2,6,6-tetramethylpiperidide (LiTMP)-tetrahydrofuran solution (1.0 mL, 0.52 mmol) as a lithiating agent (21a) was added dropwise thereto. The reaction mixture was stirred at -50°C for 5 hours, and the temperature of the reaction mixture was then increased to 0°C. To the reaction mixture was added a 0.5 M iodine-tetrahydrofuran solution (1.0 mL, 0.52 mmol) as a halogenating agent (21b) . The resulting red suspension was stirred for 12 hours while naturally rising to a room temperature. Then, to the resulting bright red suspension was added an aqueous solution of sodium thiosulfate, and the resulting organic layer was extracted with chloroform. The extract was concentrated under a reduced pressure, and the resulting crude product was washed with methanol and hexane to give an object compound (22b) as a white solid (151 mg, 67% yield).
NMR: ¹H-NMR (400 MHz, TCE-d₂): δ (ppm) 0.84-0.94 (m, 12H), 1.21-1.49 (m, 66H), 1.50-1.60 (m, 2H), 1.87-1.96 (m, 4H), 3.07 (t, 4H, J = 7.6 Hz), 8.28 (s, 2H, ArH of thiophene ring), 8.39 (d, 2H, J = 9.2 Hz, ArH), 8.47 (s, 2H, ArH of thiophene ring), 8.81 (d, 2H, J = 9.2 Hz, ArH) .

### Synthesis Example 15

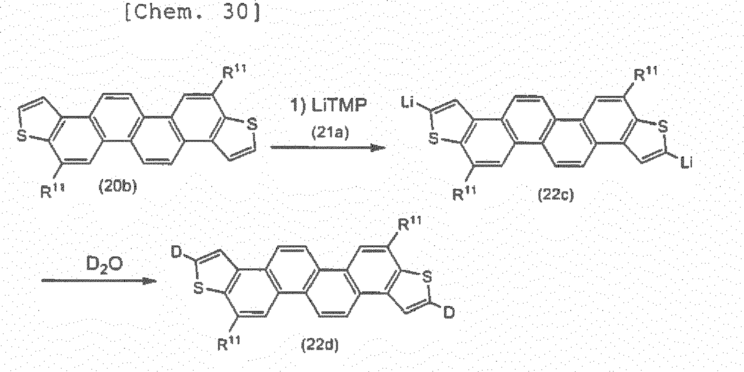

Under an argon atmosphere, while stirring a clear solution of the compound (20b) (100 mg, 0.11 mmol)/tetrahydrofuran (40 mL) at -78°C, a 0.5 M lithium 2,2,6,6-tetramethylpiperidide-tetrahydrofuran solution (0.52 mL, 0.26 mmol) was added dropwise thereto. The resulting light yellow solution was stirred at -50°C for 3 hours. Then, by allowing a portion of the reaction mixture to react with an excess amount of heavy water (D₂O) as a deuterating agent, the raw material (20b) disappeared and a deuterated product (22d) was obtained. An object product (22c) was very unstable to water and oxygen and was not separable. Thus, the formation of the object product (22c) in the reaction system was confirmed by the deuteration as described above.
NMR of the deuterated product (22d): ¹H-NMR (400 MHz, TCE-d₂): δ (ppm) 0.84-0.92 (m, 12H), 1.22-1.50 (m, 66H), 1.52-1.60 (m, 2H), 1.92-2.0 (m, 4H), 3.15 (t, 4H, J = 7.6 Hz), 7.65 (s, 2H, ArH of thiophene ring), 8.51 (d, 2H, J = 9.2 Hz, ArH), 8.55 (s, 2H, ArH), 8.86 (d, 2H, J = 9.2 Hz, ArH).

### Example 1

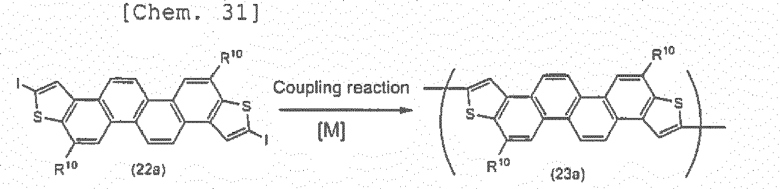

Under an argon atmosphere, while stirring a clear solution of the compound (22a) (50 mg, 0.048 mmol) /toluene (100 mL) at a room temperature, a purple solution of bis(1,5-cyclooctadiene)nickel(0) complex (15.9mg, 0.058 mmol)/2,2'-bipyridyl (9.0 mg, 0.058 mmol)/toluene (5 mL) was added dropwise thereto. The resulting black suspension was freeze-deaerated to remove oxygen in the suspension and was then stirred at 110°C for 42 hours. Thereafter, a solution of bis(1,5-cyclooctadiene)nickel (0) complex (15.9mg, 0.058 mmol)/2,2'-bipyridyl (9.0 mg, 0.058 mmol)/toluene (5 mL) was added to the suspension, and the resulting mixture was further stirred at 110°C for 42 hours. After the temperature of the reaction mixture was returned to a room temperature, the reaction mixture was put in methanol (1 L) and was stirred for 15 hours. The resulting suspension was filtered, and the resulting crude product was purified by a Soxhlet extractor (methanol, chloroform, chlorobenzene) to give a dark green solid polymer (27 mg) having a repeating unit (23a). The analysis of the resulting solid polymer by high-temperature GPC (180°C, trichlorobenzene, polystyrene internal standard) showed that the polymer had a degree of polymerization (DPn) of 5.0, a number-average molecular weight (Mn) of 4329, a weight-average molecular weight (Mw) of 7212, and a molecular weight distribution (PDI = Mw/Mn) of 1.7.

### Example 2

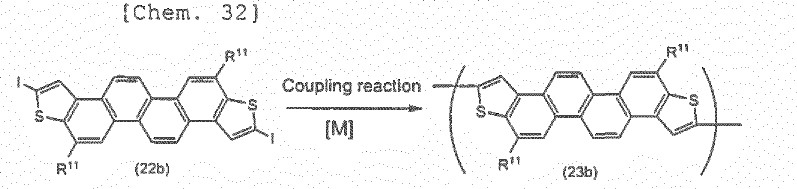

Under an argon atmosphere, while stirring a clear solution of the compound (22b) (60 mg, 0.051 mmol) /toluene (30 mL) at a room temperature, a purple solution of bis(1,5-cyclooctadiene)nickel(0) complex (33.5 mg, 0.12 mmol)/2,2'-bipyridyl (19.1 mg, 0.12 mmol)/toluene (4 mL) was added dropwise thereto. The resulting black suspension was freeze-deaerated to remove oxygen in the suspension and was then stirred at 110°C for 1.5 hours. After the temperature of the reaction mixture was returned to a room temperature, the reaction mixture was put in methanol (400 mL) and was stirred for 24 hours. The resulting suspension was filtered, and the resulting crude product was purified by a Soxhlet extractor (methanol, hexane, chloroform, chlorobenzene) to give a brown solid polymer (9 mg) having a repeating unit (23b). The analysis of the resulting solid polymer by high-temperature GPC (180°C, trichlorobenzene, polystyrene internal standard) showed that the polymer had a degree of polymerization (DPn) of 62, a number-average molecular weight (Mn) of 58205, a weight-average molecular weight (Mw) of 454022, and a molecular weight distribution (PDI) of 7.8.

### Example 3

A brown solid polymer (12 mg) having the repeating unit (23b) was obtained in the same manner as Example 2 except that the black suspension was freeze-deaerated to remove oxygen in the suspension and was then stirred at 110°C for 8 hours in Example 2. The analysis of the resulting solid polymer by high-temperature GPC (180°C, trichlorobenzene, polystyrene internal standard) showed that the polymer had a degree of polymerization (DPn) of 65, a number-average molecular weight (Mn) of 60619, a weight-average molecular weight (Mw) of 698947, and a molecular weight distribution (PDI) of 11.5.

### Example 4

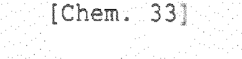

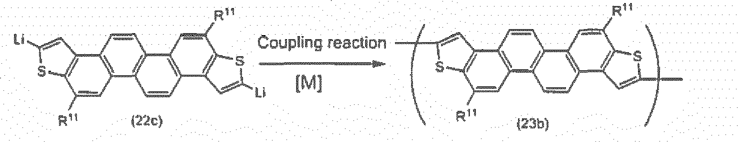

Under an argon atmosphere, the compound (22c) as an intermediate was produced in the same manner as Synthesis Example 15. While stirring a clear solution of the compound (22c) (100 mg, 0.11 mmol)/tetrahydrofuran (40 mL) at -78°C, a 0.5 M lithium 2,2,6,6-tetramethylpiperidide-tetrahydrofuran solution (0.52 mL, 0.26 mmol) was added dropwise thereto. The resulting light yellow solution was further stirred at -50°C for 3 hours and was then cooled to -78°C, and a red solution of iron(III) acetylacetonate (98.9 mg, 0.28 mmol) /tetrahydrofuran (10 mL) was added dropwise thereto. The resulting black suspension was stirred for 14 hours while rising from -78°C to a room temperature. The reaction mixture was put in methanol (1 L) and was stirred slowly for 24 hours. The resulting suspension was filtered, and the resulting crude product was extracted by a Soxhlet extractor (methanol, hexane, chloroform). The hexane extract was concentrated under a reduced pressure to give a first fraction (A) as a yellow solid polymer (8 mg). The chloroform extract was concentrated under a reduced pressure to give a second fraction (B) as a brown solid polymer (52 mg). Moreover, a third fraction (C) that was not also extracted with chloroform was obtained as a brown solid polymer (8 mg). Each fraction has the repeating unit (23b) . Each solid polymer was analyzed by high-temperature GPC (180°C, trichlorobenzene, polystyrene internal standard), and the following results were obtained.
(1) First fraction (A): degree of polymerization (DPn) : 3.3, number-average molecular weight (Mn): 3045, weight-average molecular weight (Mw): 3821, molecular weight distribution (PDI): 1.3
(2) Second fraction (B) : degree of polymerization (DPn): 9.9, number-average molecular weight (Mn): 9175, weight-average molecular weight (Mw): 14662, molecular weight distribution (PDI): 1.6
(3) Third fraction (C): degree of polymerization (DPn): 22, number-average molecular weight (Mn): 20388, weight-average molecular weight (Mw): 32502, molecular weight distribution (PDI): 1.6

### Example 5

The second fraction (B) obtained in Example 4 was evaluated for the organic semiconductor characteristics by a field-effect transistor as follows.

A silicon (Si) substrate provided with a silicon dioxide (SiO₂) insulating layer (layer thickness 500 nm) was ultrasonically washed with acetone over 3 minutes and then with 2-propanol over 3 minutes, and the washed substrate was dried at 120°C for 30 minutes. Thereafter, the dried substrate was subjected to an UV ozone treatment for 30 minutes. A self-assembled monolayer (SAM) of decyltriethoxysilane (DTS) was formed on the surface of the washed and treated substrate by vaporization.

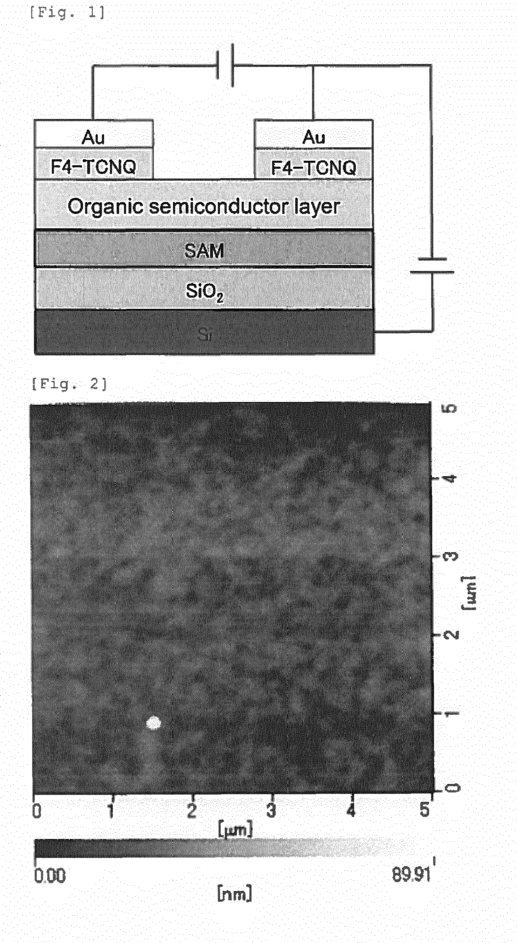

A solution of 0.24% by weight of the second fraction (B) in orthodichlorobenzene was dropped on the surface of the resulting substrate and was spin-coated (rotational frequency: 2500 rpm, rotation time: 45 s) to form a coat. Then, the coat was dried under an argon atmosphere at 150°C for 30 minutes. A metal mask was placed on the surface of the dried coat, and tetrafluorotetracyanoquinodimethane (F4-TCNQ) (thickness: about 2 nm) as a carrier injection layer and gold (thickness: 40 nm) as a source electrode and a drain electrode were vacuum-deposited to produce a device element (top-contact bottom-gate type, channel length: 100 µm, channel width: 2 mm). Fig. 1 shows a schematic view of the element.

The carrier mobility (µ) of the produced device element was measured using a semiconductor parameter analyzer (model number "keithley 4200", manufactured by Keithley Instruments). The carrier mobility (µ) was 6.9 × 10⁻³ cm²/Vs.

### Example 6

The surface of the organic semiconductor of the device element produced in Example 5 was observed by an atomic force microscope (AFM), and the arithmetic average roughness (Ra) was 2.3. The results are shown in Fig. 2.

The results show that the organic polymer in an embodiment of the present invention has an excellent film formability and is formable into a smooth thin film.

### INDUSTRIAL APPLICABILITY

In an embodiment of the present invention, the organic polymer is a π-electron-conjugated polymer and is useful for forming a low-resistant and high-conductive organic semiconductor (a polymeric organic semiconductor) . The organic semiconductor is utilizable for various electronic devices, for example, a semiconductor device [for example, a semiconductor element, e.g., a rectifier element (a diode), a switching element, or a transistor [a junction transistor (a bipolar transistor), a field-effect transistor (a unipolar transistor)], and a photoelectric conversion element (e.g., a solar cell element and an organic EL element)] .

## Claims

1. An organic polymer having a repeating unit represented by the following formula (I): 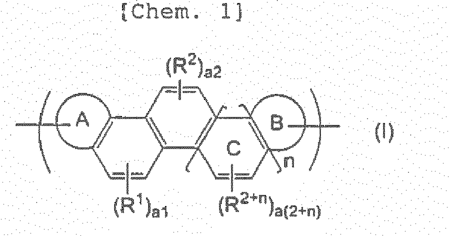 wherein a ring A and a ring B each independently represent an aromatic hydrocarbon ring or an aromatic heterocyclic ring; n denotes an integer of 0 or 1 to 6; R¹ to R²⁺ⁿ each independently represent a substituent; numbers a1 to a (2+n) each independently denote an integer of 0 to 2; and a ring C represents a benzene ring ortho-fused sequentially and nonlinearly to an adjacent benzene ring depending on the number of n.

2. The organic polymer according to claim 1, which has a repeating unit represented by at least one formula of the following formulae (I-1) to (I-5): 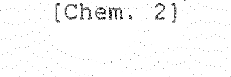 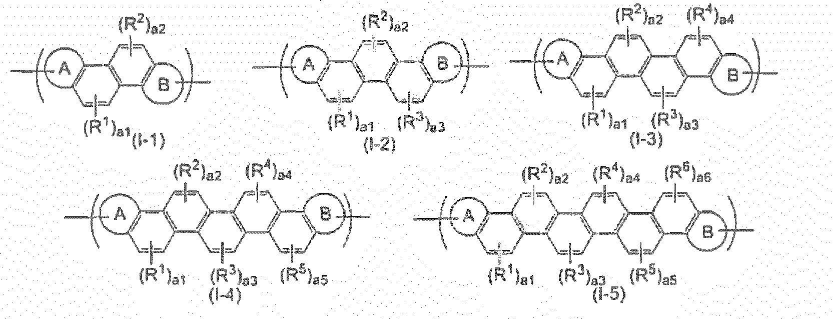 wherein R¹ to R⁶ each independently represent an alkyl group, an aryl group, an alkoxy group, or an alkylthio group; numbers a1 to a6 each independently denote an integer of 0 to 2; and the ring A and the ring B have the same meanings as defined in claim 1.

3. The organic polymer according to claim 1, which has a repeating unit represented by the following formula (I-3): 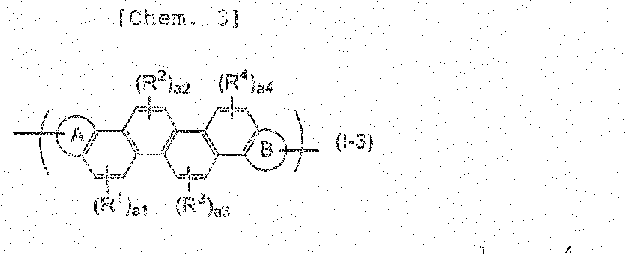 wherein at least one of R¹ to R⁴ represents a straight-chain or branched-chain C₄₋₂₈alkyl group or a straight-chain or branched-chain C₄₋₂₈alkoxy group; numbers a1 to a4 each independently denote 0 or 1; at least one of the numbers a1 to a4 denotes 1; and the ring A and the ring B have the same meanings as defined in claim 1.

4. The organic polymer according to any one of claims 1 to 3, wherein the ring A and the ring B represent an aromatic ring selected from the group consisting of a thiophene ring, a furan ring, a pyrrole ring, a selenophene ring, and a benzene ring.

5. The organic polymer according to any one of claims 1 to 4, which has a repeating unit represented by the following formula (I-3a1) or (I-3b1): 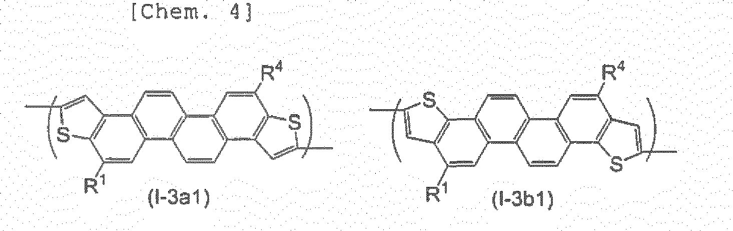 wherein R¹ and R⁴ represent a straight-chain or branched-chain C₆₋₂₆alkyl group or a straight-chain or branched-chain C₆₋₂₆alkoxy group.

6. A process for producing an organic polymer recited in any one of claims 1 to 5, the process comprising: subjecting a compound represented by the following formula (Ia): 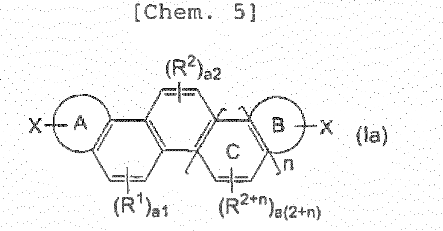 wherein X represents a hydrogen atom, a halogen atom, a lithium atom, or -MgX¹ (wherein X¹ represents a halogen atom), the ring A, the ring B, n, R¹ to R²⁺ⁿ, and the numbers a1 to a (2+n) have the same meanings as defined in claim 1,
to a coupling reaction.

7. A composition for forming an organic semiconductor, the composition comprising an organic polymer recited in any one of claims 1 to 5 and an organic solvent.

8. A process for producing an organic semiconductor, the process comprising: coating at least one side of a base material with a composition recited in claim 7 and drying the coated layer to form an organic semiconductor.

9. An organic semiconductor comprising an organic polymer recited in any one of claims 1 to 5.

10. An electronic device comprising an organic polymer recited in any one of claims 1 to 5.

11. A semiconductor element comprising an organic polymer recited in any one of claims 1 to 5.

12. The semiconductor element according to claim 11, which is one selected from the group consisting of a switching element, a rectifier element, and a photoelectric conversion element.
